(19) Europäisches Patentamt / European Patent Office / Office européen des brevets

(11) **EP 2 409 276 B1**

(12) **FASCICULE DE BREVET EUROPEEN**

(45) Date de publication et mention de la délivrance du brevet:
**29.08.2018 Bulletin 2018/35**

(51) Int Cl.:
***G06T 7/00*** *(2017.01)*

(21) Numéro de dépôt: **10715941.0**

(22) Date de dépôt: **15.03.2010**

(86) Numéro de dépôt international:
**PCT/FR2010/050459**

(87) Numéro de publication internationale:
**WO 2010/106277 (23.09.2010 Gazette 2010/38)**

(54) **PROCEDE DE TRAITEMENT D'IMAGE POUR L'ANALYSE DE CIRCUITS INTEGRES, ET SYSTEME DE MISE EN OEUVRE DU PROCEDE**

BILDVERARBEITUNGSVERFAHREN ZUR ANALYSE VON INTEGRIERTEN SCHALTUNGEN UND SYSTEM ZUR DURCHFÜHRUNG DES VERFAHRENS

IMAGE PROCESSING METHOD FOR THE ANALYSIS OF INTEGRATED CIRCUITS, AND SYSTEM FOR IMPLEMENTING SAID METHOD

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **18.03.2009 FR 0951724**

(43) Date de publication de la demande:
**25.01.2012 Bulletin 2012/04**

(73) Titulaire: **Centre National d'Etudes Spatiales 75001 Paris (FR)**

(72) Inventeurs:
• SANCHEZ, Kevin
**31750 ESCALQUENS (FR)**
• PERDU, Philippe
**31100 Toulouse (FR)**

(74) Mandataire: **Gaillarde, Frédéric F. Ch. et al Cabinet Germain & Maureau 31-33, rue de la Baume 75008 Paris (FR)**

(56) Documents cités:
**WO-A-2004/053780      US-A1- 2005 024 057 US-A1- 2005 231 219**

• **DESPLATS R ET AL: "A new approach for faster ic analysis with pica: stpc-3d" PHYSICAL AND FAILURE ANALYSIS OF INTEGRATED CIRCUITS, 2003. IPFA 2003. PROCEEDINGS OF THE 10TH INTERNATIONAL SYMPOSIUM ON THE 7-11 JULY 2003, PISCATAWAY, NJ, USA,IEEE, 7 juillet 2003 (2003-07-07), pages 45-53, XP010651032 ISBN: 978-0-7803-7722-6**
• **DESPLATS R ET AL: "Faster IC analysis with PICA Spatial Temporal Photon Correlation and CAD autochanneling" MICROELECTRONICS RELIABILITY ELSEVIER UK, vol. 43, no. 9-11, septembre 2003 (2003-09), pages 1663-1668, XP007909766 ISSN: 0026-2714**
• **DESPLATS R ET AL: "Positive photon discrimination for ultra low voltage IC analysis" RELIABILITY PHYSICS SYMPOSIUM PROCEEDINGS, 2004. 42ND ANNUAL. 2004 IEE E INTERNATIONAL PHOENIX, AZ, USA APRIL 25-29, 2004, PISCATAWAY, NJ, USA,IEEE, 25 avril 2004 (2004-04-25), pages 361-369, XP010711254 ISBN: 978-0-7803-8315-9**

EP 2 409 276 B1

## Description

L'invention se rapporte à un procédé de traitement d'image pour l'analyse de circuits intégrés, à un système et à un programme d'ordinateur de mise en oeuvre du procédé.

L'émission de lumière dynamique dans la bande infrarouge est à la base depuis la fin des années 80 de techniques connues de localisation de défauts sur des circuits électroniques intégrés.

En effet, chacun des transistors qui constituent ces circuits est susceptible d'émettre avec une certaine probabilité un photon ou quantum d'énergie de rayonnement électromagnétique lors de sa commutation, de l'état bloqué à l'état passant, ou inversement, de l'état passant à l'état bloqué, le transistor passant par un état de saturation.

En fait, cette technique a longuement été utilisée sur la face avant des circuits intégrés, avant d'être étendue dans la fin des années 90 à la face arrière. En effet, cela s'adapte mieux aux technologies récentes, où la zone active du circuit, c'est-à-dire la zone où sont situés les composants élémentaires tels que transistors, capacités, résistances et diodes, est de plus en plus masquée par les niveaux d'interconnexions de plus en plus nombreux, ou par les soudures (bondings en anglais) de certains procédés d'assemblage.

Ainsi, grâce à cette technique et à l'aide d'un capteur optique sensible aux photons isolés, il est possible de localiser chaque transistor en commutation à chaque instant, et donc d'analyser en détail le fonctionnement d'un circuit intégré pendant un cycle de fonctionnement, sous réserve que le capteur permette de déterminer la position spatiale de chaque photon détecté.

Un dispositif de mesure selon cette technique, équipé d'une tel capteur d'image et d'un testeur électrique permet ainsi localiser un ou plusieurs défauts par comparaison du fonctionnement du circuit défaillant, soit à son fonctionnement théorique déterminé d'après une simulation, soit au fonctionnement pratique d'un circuit en bon état de marche.

Le capteur ne faisant que lister les coordonnées spatiale et/ou temporelle de chaque photon détecté, il est indispensable de traiter les données brutes émises par le capteur avant de pouvoir les interpréter correctement. Ce traitement postérieur à l'acquisition des données, appelé en anglais post-processing, est mis en oeuvre après acquisition de données complètes, qualifiées de brutes après réarrangement et enregistrées dans une base de données.

Il est connu, d'après le document intitulé « STPC-PICA : Spatial Temporal Photon Correlation for Faster IC analysis » de R. Desplats et al. du CNES (French Space Agency) et le document intitulé « A new approach for faster IC analysis with PICA » de R. Desplats et al. (Physical and Faiure Analysis of Integrated Circuits, 2003, IPFA 2003, pages 45-53), d'utiliser un filtrage dénommé STPC (Spatial Temporal Photon Correlation) permettant de supprimer le bruit, constitué par tous les photons qui ne correspondent pas une commutation du transistor. Le filtrage STPC décrit dans le document cité ci-dessus comprend les étapes consistant, d'abord à pondérer chacun des photons détectés par le capteur en fonction du nombre de photons voisins spatio-temporels qu'il a, puis à appliquer un seuil de filtrage pour supprimer les photons qui n'ont pas un poids suffisamment significatif.

Bien que le filtrage STPC constitue un bon compromis entre efficacité et temps de calcul, du bruit non filtré existe encore qui surcharge les bases de données et induisent des temps de traitement supplémentaires inutiles.

Le problème technique est d'améliorer la qualité du filtrage STPC ou similaire, d'alléger les bases de données et de diminuer le temps de traitement. L'invention est définie par les revendications indépendantes. A cet effet, l'invention a pour objet un procédé de traitement d'image pour l'analyse de défauts d'un circuit électronique intégré, le procédé étant mis en oeuvre à partir d'une première base de données d'une image contenant des données d'acquisition de mesure de photons isolés et détectés par un dispositif d'acquisition de mesures optiques, comprenant les étapes consistant à

- déterminer à partir de la première base de données d'acquisition de mesures des photons isolés ($i_{acq}$), une base de données de photons filtrés (i) contenant pour chaque photon filtré (i) un enregistrement qui comprend :
- une position (P(i)) spatiale et/ou temporelle du photon filtré (i) définie dans un repère spatial et/ou temporel à <u>n</u> dimensions, et
- un poids scalaire (W(i)) associé au photon filtré (i),

caractérisé en ce que le procédé comprend au moins une étape de regroupement élémentaire de photons filtrés autour d'un photon filtré prédéterminé (k) central en un évènement (ev(k)), la ou chaque étape de regroupement élémentaire comprenant :

- la recherche autour du photon central (k) de position (P(k)) de photons (reg(k)) de positions respectives (P(reg(k))) contenus dans une fenêtre spatiale et/ou temporelle (Fev(k)) d'événement contenant (P(k)) et d'amplitude ($\Delta$Tmaxev) prédéterminée,
- lorsqu'au moins un photon (P(reg(k))) a été trouvé, le regroupement entre eux des photons trouvés dans la fenêtre (Fev(k)) en créant un évènement ((ev(k))) associé au photon central (k) comme un enregistrement qui comprend :

une position de l'évènement ($P_{moy}(k)$) égale à une première fonction des positions des photons (k, Reg(k)) contenus dans la fenêtre (Fev(k)),

un poids d'événement (Wev(k)) égal à une deuxième fonction des poids scalaires (W(k), W(reg(k)) de la totalité des photons contenus dans la fenêtre (Fev(k)).

Suivant des modes particuliers de réalisation, le procédé de traitement comporte l'une ou plusieurs des caractéristiques suivantes :

- l'enregistrement d'un évènement comprend les coordonnées maximales et minimales des photons (k, reg(k)) contenus dans la fenêtre (Fev(k)) ;
- la première fonction est une moyenne non pondérée des positions ($P_{moy}(k)$) des photons (k, reg(k)) contenus dans la fenêtre (Fev(k)) ;
- la première fonction est une moyenne pondérée des positions ($P_{moy}(k)$) des photons (k,reg(k)) contenus dans la fenêtre (Fev(k)) affectés de leur poids scalaire respectif (W(k), W(reg(k))), de sorte que la position de l'événement (ev(k)) est un barycentre des photons (k, reg(k)) ;
- la deuxième fonction est la somme des poids (W(k), W(reg(k)) respectifs des photons (k, reg(k) contenus dans la fenêtre (Fev(k)) ;
- le procédé comprend une phase de regroupement de tous les photons filtrés (i) de la base de données en des évènements, la phase de regroupement consistant à appliquer l'étape de regroupement élémentaire à chaque photon (i) une seule fois, le photon (i) étant considéré soit comme un photon central, soit comme un photon trouvé dans une fenêtre d'évènement ;
- les évènements créés (ev(k)) sont rassemblés dans une base de données ne contenant que des événements ;
- le procédé comprend une étape de filtrage des évènements (ev(k)) consistant à supprimer les évènements (ev(k)) dont le poids d'événement (Wev(k)) est inférieur à une valeur de seuil prédéterminée (Sev), les évènements restants étant des évènements filtrés (ev($k_{filtre}$)) ;
- le procédé comprend une étape de création d'une image des évènements filtrés, respectivement des évènements non filtrés (ev(k)), représentant le ou les évènements filtrés (ev($k_{filtre}$)), respectivement le ou les évènements non filtrés (ev(k)) sous la forme de segments, de carrés ou de volumes ayant chacun une position, une taille et une couleur, la taille et la position du segment, du carré ou du volume étant déterminée par les cordonnées de l'événement filtré (ev($k_{filtre}$)), respectivement de l'événement non filtré (ev(k)) et la couleur est fonction du poids (Wev($k_{filtre}$)) de l"évènement filtré, respectivement du poids (Wev(k)) de l'évènement non filtré (ev(k)) ;
- le procédé comprend une étape de comparaison d'au moins un évènement (ev(k)) déterminé à partir de la première base de données à au moins un évènement déterminé à partir d'une deuxième base de données dite de référence et correspondant à un circuit électronique identique en bon état de fonctionnement, et une étape d'identification des évènements non semblables dérivés respectivement de la première base de données et la deuxième base de données ;
- le procédé comprend une étape de recueil de données d'acquisition de mesures de photons isolés ($i_{acq}$) et détectés par un dispositif d'acquisition de mesures optiques, les données de mesures formant une image ;
- la position (P(i)) spatiale et/ou temporelle du photon filtré (i) est définie par n coordonnées ($x_j(i)$ avec j entier variant de 1 à n, correspondant à un emplacement et/ou un moment d'émission du photon filtré (i), les n coordonnées étant prises ensemble dans un n-uplet formé par n-1 coordonnées spatiales et une coordonnée temporelle (t), les coordonnées spatiales étant définies par rapport à un repère spatial d'émission des photons du circuit électronique et la coordonnée temporelle (t) étant définie par rapport à une référence temporelle d'un signal électrique d'excitation du circuit électronique,

la taille maximale d'évènement (ΔTmaxev) est formée par un n-uplet (ΔTmaxev$_j$), j entier variant de 1 à n, et

la fenêtre spatiale et/ou temporelle (Fev(k)) d'événement est centrée autour de (P(k)) et d'amplitude (ΔTmaxev) et s'écrit

$$\prod_{j=1}^{n}\left[x_j(k) - \Delta T \max ev_j ; x_j(k) + \Delta T \max ev_j\right] ;$$

comme un ensemble produit cartésien

- l'étape de détermination d'une base de données de photons filtrés (i) à partir de la base de données d'acquisition de mesures des photons isolés comprend une étape d'arrangement préliminaire des donnés d'acquisition de mesures des photons mesurés ($i_{acq}$) en des données brutes de photons bruts ($i_{brut}$) et une étape de conversion des données brutes des photons bruts ($i_{brut}$) en les données de photons filtrés (i) ;

les données brutes contiennent pour chaque photon brut ($i_{brut}$) un enregistrement qui comprend :

- une position ($P(i_{brut})$) spatiale et/ou temporelle du photon brut ($i_{brut}$) définie dans un repère spatial et/ou temporel à n dimensions, et
- une valeur scalaire de sensibilité du capteur optique ($S(i_{brut})$) associée au photon brut ($i_{brut}$) ; et

l'étape de conversion des données brutes des photons bruts ($i_{brut}$) en les données de photons filtres (i) comprend une étape de pondération de recherche autour du photon ($i_{brut}$) de position ($P(i_{brut})$) de photons ($vois(i_{brut})$) de positions respectives ($P(vois(i_{brut}))$) contenus dans une fenêtre spatiale et/ou temporelle ($F_W(i_{brut})$) de pondération de photon, la fenêtre de pondération de photon ($F_W(i)$) contenant de ($P(i_{brut})$) et étant d'amplitude ($\Delta T_W$), et de calcul du poids ($W(i_{brut})$) associé au photon pondéré ($i_{brut}$) égal à une troisième fonction des sensibilités ($S(vois(i_{brut}))$) des photons ($i_{brut}$, $vois(i_{brut})$) trouvés dans la fenêtre ($F_W(i_{brut})$) ;

- la troisième fonction est la somme des sensibilités ($S(vois(i_{brut}))$) des photons ($i_{brut}$, $vois(i_{brut})$) trouvés dans la fenêtre ($F_W(i_{brut})$) ;
- l'étape de conversion des données brutes des photons bruts ($i_{brut}$) en les données de photons filtres (i) comprend une étape de filtrage des photons bruts ($i_{brut}$) pondérés succédant à l'étape de pondération consistant à supprimer les photons bruts pondérés dont le poids ($W(i_{brut})$) est inférieur à une valeur de seuil de filtrage de photons prédéterminée ($S_{filt}$), les photons bruts pondérés restants constituant les photons filtrés (i) ;
- la position ($P(i_{brut})$) spatiale et/ou temporelle du photon filtré (i) est définie par n coordonnées ($x_j(i_{brut})$ avec j entier variant de 1 à n, correspondant à un emplacement et/ou un moment d'émission du photon brut ($i_{brut}$), les n coordonnées étant prises ensemble dans un n-uplet formé par n-1 coordonnées spatiales et une coordonnée temporelle (t), les coordonnées spatiales étant définies par rapport à un repère spatial d'émission des photons du circuit électronique et la coordonnée temporelle (t) étant définie par rapport à une référence temporelle d'un signal électrique d'excitation du circuit électronique,
la taille de pondération de photon brut ($\Delta T_W$) est formée par un n-uplet ($\Delta T_{Wj}$), et
la fenêtre spatiale et/ou temporelle ($F_W(i_{brut})$) est centrée autour de ($P(i_{brut})$) et d'amplitude ($\Delta T_W$) et s'écrit comme

$$\prod_{j=1}^{n} \left[ x_j(i_{brut}) - \Delta T_{wj} ; x_j(i_{brut}) + \Delta Tw_j \right],$$

un ensemble produit cartésien et

- n est un entier inférieur ou égal à 3 et les coordonnées ($x_j(i)$ d'un photon filtré (i), respectivement ($x_j(i_{brut})$ d'un photon brut ($i_{brut}$) avec j entier variant de 1 à 3, correspondent à un emplacement et/ou un moment d'émission du photon filtré (i) respectivement du photon ($i_{brut}$), les n coordonnées étant prises ensemble dans un triplet formé par une première coordonnée spatiale (x), une deuxième coordonnée spatiale (y) et une coordonnée temporelle (t), les coordonnées spatiales (x) et (y) étant définies par rapport à un repère spatial d'un plan d'émission des photons du circuit électronique et la coordonnée temporelle (t) étant définie par rapport à une référence temporelle d'un signal électrique d'excitation du circuit électronique ;
- le nombre n de dimensions d'acquisition est égal à 3 avec deux dimensions spatiales selon les coordonnées (x), (y) et une dimension temporelle t, l'étape de pondération des photons est un procédé de corrélation spatio-temporelle STPC (Spatial Temporal Photo Correlation) avec la taille de la fenêtre de pondération ($\Delta T_W$) formé par un triplet (dl, dl, dt) dans lequel les composantes spatiales de la taille ($\Delta T_W$) de la fenêtre sont identiques ;
- le procédé utilise une technique d'acquisition comme l'émission de lumière statique, le nombre $\underline{n}$ de dimensions d'acquisition est égal à 2 avec deux dimensions spatiales selon les cordonnées (x) et (y), l'étape de pondération des photons est un procédé de corrélation spatiale avec la taille de la fenêtre de pondération ($\Delta T_W$) formé par un doublet (dl, dl) dans lequel les deux composantes spatiales de la taille de la fenêtre sont identiques ; et
- le procédé utilise une technique d'acquisition comme l'émission à résolution temporelle TRE (Time Resolved Emission) de lumière statique, le nombre $\underline{n}$ de dimensions d'acquisition est égal à 1 avec une unique dimension temporelle selon la coordonnée temporelle (t), l'étape de pondération des photons est un procédé de corrélation temporelle avec la taille de la fenêtre de pondération ($\Delta T_W$) formé par une valeur (dt).

L'invention a également pour objet un produit programme d'ordinateur comprenant des instructions de programme pour mettre en oeuvre les étapes du procédé tel que défini ci-dessus lorsque ledit programme fonctionne sur un ordinateur.

L'invention a également pour objet un système de mise en oeuvre du procédé pour l'analyse de défauts d'un circuit électronique intégré comprenant

un dispositif d'acquisition de mesures optiques apte à détecter des photons isolés émis par le circuit électronique et à fournir des données d'acquisition de mesure des photons isolés détectés ($i_{acq}$),

une mémoire apte à sauvegarder les données d'acquisition de mesure des photons isolés détectés formant une base de données,

un calculateur apte à déterminer à partir de la base de données d'acquisition de mesures des photons isolés une base de données de photons filtrés (i) contenant pour chaque photon filtré (i) un enregistrement qui comprend :

- une position P(i) spatiale et/ou temporelle du photon filtré (i) définie dans un repère spatial et/ou temporel à n dimensions, avec n entier inférieur ou égal à 3, par n coordonnées ($x_j$(i) avec j entier variant de 1 à n, correspondant à un emplacement et/ou un moment d'émission du photon filtré (i), les n coordonnées étant prises ensemble dans un triplet formé par une première coordonnée spatiale (x), une deuxième cordonnée spatiale (y) et une coordonnée temporelle (t), les coordonnées spatiales (x) et (y) étant définies par rapport à un repère spatial d'un plan d'émission des photons du circuit électronique et la coordonnée temporelle (t) étant définie par rapport à une référence temporelle d'un signal électrique d'excitation du circuit électronique, et
- un poids scalaire (W(i)) associé au photon filtré (i),

caractérisé en ce que le calculateur est apte à mettre en oeuvre une étape de regroupement élémentaire de photons autour d'un photon prédéterminé (k) central en un évènement (ev(k)), l'étape de regroupement élémentaire consistant à :

- une taille maximale d'évènement ($\Delta$Tmaxev) formée par un n-uplet ($\Delta$Tmaxev$_j$) étant prédéterminée, rechercher autour du photon prédéterminé (k) de position (P(k)) les photons (reg(k)) de positions respectives (P(reg(k))) contenus dans une fenêtre spatiale et/ou temporelle (Fev(k)) d'évènement, la fenêtre d'événement (Fev(k)) étant centrée autour de (P(k)) et d'amplitude ($\Delta$Tmaxev) et s'écrivant comme ensemble produit

$$\prod_{j=1}^{n}\left[x_j(k) - \Delta T \max ev_j ; x_j(k) + \Delta T \max ev_j\right],$$

- lorsqu'au moins un photon (reg(k)) a été trouvé, regrouper entre eux les photons trouvés dans la fenêtre (Fev(k)) en créant un évènement (ev(k)) associé au photon (k) comme un enregistrement qui comprend :

    une position de l'évènement égal à la moyenne ($P_{moy}$(k)) des positions des photons (reg(k)) contenus dans la fenêtre (Fev(k)) et du photon (k),
    les coordonnées maximales et minimales des photons contenus dans la fenêtre (Fev(k)), le photon (k) y compris,
    un poids d'évènement (Wev(k)) égal à la somme des poids de la totalité des photons contenus dans la fenêtre (Fev(k)).

L'invention sera mieux comprise à la lecture de la description d'une unique forme de réalisation qui va suivre, donnée uniquement à titre d'exemple et faite en se référant aux dessins sur lesquels :

- la Figure 1 est une vue d'un système d'imagerie spatio-temporelle pour l'analyse de défaut de circuit intégré selon l'invention,
- la Figure 2 est un ordinogramme d'un procédé de traitement mis en oeuvre par le système d'imagerie décrit à la figure 1,
- la Figure 3 est une vue détaillée de l'étape de traitement préliminaire décrite dans l'organigramme de la Figure 2,
- la Figure 4 est une vue détaillée de l'étape de pondération des photons bruts décrite dans l'organigramme de la Figure 2,
- la Figure 5 est une vue détaillée de l'étape de filtrage des photons bruts décrite dans l'organigramme de la Figure 2,
- la Figure 6 est une vue détaillée de l'étape de vectorisation décrite dans l'organigramme de la Figure 2,
- la Figure 7 est une vue détaillée de l'étape de regroupement des photons filtrés en évènements décrite dans l'ordinogramme décrit à la figure 6,
- la Figure 8 est une vue détaillée de l'étape de comparaison des évènements de deux bases de données décrite dans l'ordinogramme de la figure 2,
- la Figure 9 est une vue détaillée de l"étape de détermination d'évènements semblables décrite dans l'ordinogramme de la Figure 8,
- les Figures 10 et 11 sont des images de photons bruts émis respectivement par un circuit défaillant et un circuit fonctionnel,
- les Figures 12 et 13 sont des images de photons filtrés déterminés respectivement à partir des images des Figures 10 et 11,
- les Figures 14 et 15 sont des images des évènements déterminés respectivement à partir des images des Figures 12 et 13,
- la Figure 16 est une image de comparaison des évènements des Figures 14 et 15, et

- la Figure 17 est une image des premiers évènements divergents obtenue à partir de l'image de la Figure 16.

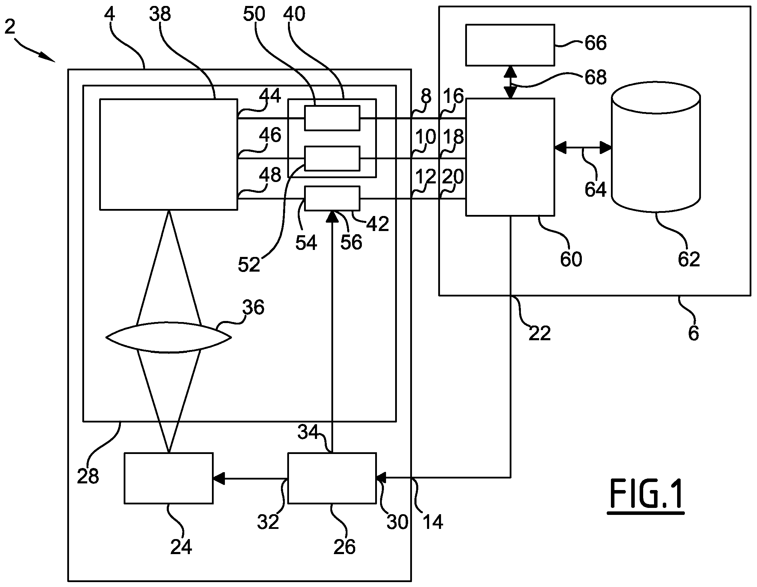

Suivant la Figure 1, le système 2 d'analyse de défauts dans un circuit intégré comprend un dispositif 4 d'imagerie ou d'acquisition de mesures de photons PICA (dénomination en anglais de Picosecond Imaging Circuit Analysis) et un moyen 6 de traitement des données de mesures acquises et de coordination des tâches exécutés par le dispositif d'imagerie 4, le moyen de traitement et de coordination 6 et le dispositif d'imagerie 4 étant connectés entre eux.

Le dispositif d'imagerie 4 comprend trois bornes de sortie 8, 10, 12 et une borne d'entrée 14.

Le dispositif d'imagerie 4 est apte à être commandé par le moyen de traitement et de coordination 6 au travers de la borne d'entrée 14 et à fournir des données de mesures acquises de photons $i_{acq}$ au travers des trois bornes de sortie 8, 10 et 12.

Le moyen de traitement et de coordination 6 comprend trois bornes d'entrée 16, 18, 20, connectées respectivement aux trois bornes de sortie 8, 10, 12 du dispositif d'imagerie 4, et une borne de sortie 22 connectée à la borne d'entrée 14.

Le moyen de traitement et de coordination 6 est apte à commander le dispositif d'imagerie 4 au travers de la borne de sortie 22 et à recevoir des données de mesures acquises des photons $i_{acq}$ issues du dispositif d'imagerie 4 au travers des trois bornes d'entrée 16, 18, 20.

Le dispositif d'imagerie 4 comprend un circuit électronique intégré 24 à tester ou échantillon, un testeur électrique 26 et un capteur 28 d'image de photons isolés PICA.

Le testeur électrique 26 comprend une borne d'entrée 30, connectée à la borne 14 et apte à recevoir un signal de commande issu du moyen de traitement et de coordination 6, une première borne de sortie 32 connectée au circuit électronique intégré 24 et une deuxième borne de sortie 34 connectée au capteur d'image 28.

Le testeur électrique 26 est apte à envoyer au travers de la première borne de sortie 32 une séquence électrique de test, réalisée sous la forme d'un motif d'impulsions en série et/ou en parallèle, au circuit intégré 24 lorsqu'il reçoit en sa borne d'entrée 30 une commande issue du moyen de coordination 6.

La séquence électrique de test peut également être programmée à l'intérieur du circuit intégré 24, auquel cas le testeur électrique 26 est apte à envoyer un simple signal de déclenchement sous la forme d'une impulsion au circuit intégré 24.

Le testeur électrique 26 est apte à envoyer au capteur d'image 28 au travers de la deuxième borne de sortie 34 la même séquence de test ou le même signal de déclenchement envoyés au travers de la première borne de sortie 32, de manière à fournir une référence temporelle de synchronisation.

Le capteur d'image 28 comprend une lentille 36, un détecteur de photons 38, un moyen 40 de capture spatiale des composantes spatiales des photons isolés détectés, un moyen 42 de capture temporelle de la composante temporelle respective de chacun des photons isolés détectés.

La lentille 36 est apte à récupérer les photons émis par l'ensemble des composants élémentaires du circuit électronique 24 sur toute son étendue et à les réacheminer sous la forme d'une image planaire au détecteur de photons 38.

Le détecteur de photons 38 est apte à détecter chacun les photons émis par le circuit électronique 24 via la lentille 38.

Le détecteur de photons 38, compatible avec les exigences de la technique PICA comprend par exemple des multiplicateurs de photons à canal unique ou des photodiodes à avalanche en silicium, ou encore des multiplicateurs de photons d'imagerie plane à micro-canaux, formant un réseau plan de cellules élémentaires de détection de photons isolés.

Chaque cellule élémentaire du détecteur ou pixel, repérée dans une grille planaire par deux coordonnées spatiales x et y qui lui ont été affectées de manière prédéterminée, est apte à créer en une sortie propre non représentée un signal électrique indiquant qu'un photon isolé a été détecté.

Le détecteur de photons 38 comprend un convertisseur classique, non représenté sur la Figure 1, apte à partir des signaux fournis par les cellules élémentaires, à convertir chaque photon isolé détecté en une information spatiale de l'emplacement de la cellule ayant reçu le photon isolé et une information temporelle du moment de détection.

L'information spatiale associée au photon isolé comprend la première cordonnée spatiale x et la deuxième coordonne spatiale y de la cellule l'ayant détecté, tandis que l'information temporelle est fournie sous la forme d'une impulsion correspondant au moment de détection du photon.

Le détecteur de photons 38 est apte à fournir respectivement l'information spatiale x, y et l'information temporelle au moyen 40 de capture spatiale et au moyen 42 de capture temporelle au travers de bornes de sortie 44, 46, 48.

Le moyen de capture spatiale 40 comprend une première unité de capture spatiale 50 et une deuxième unité de capture spatiale 52 connectées respectivement en entrée aux bornes de sortie 44, 46 du détecteur 38 et en sortie aux bornes 8, 10.

La première unité de capture spatiale 50 et la deuxième unité spatiale 52 sont aptes à recevoir respectivement les informations spatiales x et y de chaque photon associé et à les retransmettre à l'unité de traitement et de coordination 6 au travers des bornes de sortie 8, 10 sous la forme de composantes spatiales x, y associées au photon détecté $i_{acq}$.

Le moyen de capture temporelle 42 comprend une première borne d'entrée 54 et une deuxième borne d'entrée 56 raccordées respectivement à la borne de sortie 48 du détecteur 38 et à la deuxième borne de sortie 34 du testeur électrique 26.

Le moyen de capture temporelle 42 est apte à convertir l'information temporelle, associée à un photon détecté et reçue à la première borne d'entrée 54, en une composante temporelle $\underline{t}$ du photon référencée par rapport au signal de séquence ou de déclenchement de séquence émis par le testeur électrique 26 et servant de référence temporelle.

Ainsi, le dispositif de mesure 4 est apte à fournir au moyen de traitement et de coordination 6 les deux composantes spatiales x, y et la composante temporelle $\underline{t}$ associées à chaque photon isolé détecté.

Le moyen de traitement et de coordination 6 comprend un calculateur 60 raccordé aux bornes d'entrée 16, 18, 20 et à la borne de sortie 22, une mémoire 62 de sauvegarde de bases de données connectée au calculateur 60 par une liaison bidirectionnelle 64.

Le moyen de traitement et de coordination 6 comprend également une unité d'interface utilisateur 66 connectée au calculateur 60 par une liaison bidirectionnelle 68.

L'unité d'interface utilisateur 66 est apte à fournir au calculateur 60 des données entrées par l'utilisateur, à recevoir des images du calculateur 60 et les afficher.

Le dispositif d'imagerie 4 fournit ainsi des données de mesures de photons isolés $i_{acq}$ à trois dimensions spatio-temporelles, sous la forme de deux coordonnées spatiales $x(i_{acq})$, $y(i_{acq})$ et une coordonnée temporelle $t(i_{acq})$.

Le système 2 permet de filtrer les photons reçus en utilisant la méthode de pondération dénommée STPC (en anglais de Spatial Temporal Photon Correlation).

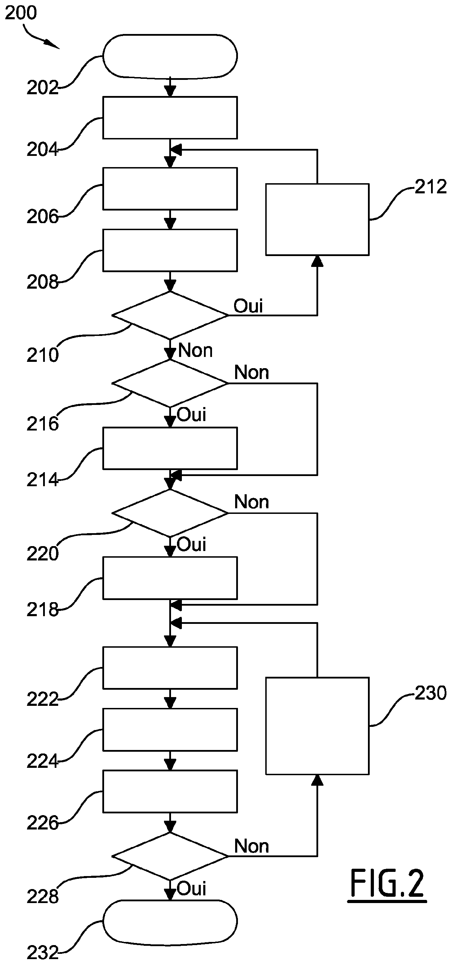

Suivant la figure 2, un procédé de traitement PICA des données de mesures d'acquisition des photons isolés collectées par le dispositif d'imagerie 4 comprend un ensemble d'étapes.

Ici, le procédé de traitement utilise une méthode de pondération STPC des photons détectés.

Dans une première étape d'initialisation 202, des paramètres de pondération associés à la méthode de pondération STPC sont entrés par l'utilisateur au travers de l'interface utilisateur 66.

Les paramètres de pondération comprennent la taille $\Delta T_w$ d'une fenêtre spatio-temporelle de pondération se présentant sous la forme d'un triplet (dl, dl, dt), dl étant la taille d'une composante spatiale quelconque de la fenêtre et dt étant la taille temporelle de la fenêtre.

Dans une étape suivante de traitement préliminaire 204, les données de mesures $x(i_{acq})$, $y(i_{acq})$, $t(i_{acq})$ associées à chaque photon désigné par un indice distinct $i_{acq}$ et acquises par le dispositif d'imagerie 4 sont réarrangées dans une base de données en tant que données brutes des photons bruts $i_{brut}$ détectés.

Ensuite dans une étape de pondération 206, chaque photon brut $i_{brut}$ est pondéré en lui affectant un poids $W(i_{brut})$ suivant la méthode de pondération STPC et les paramètres choisis associés.

Une étape principale, non représentée sur la figure 2 et mise en oeuvre au sein de l'étape de pondération 206 consiste à calculer pour chaque photon $i_{brut}$ un produit de convolution spatio-temporelle sur trois dimensions, deux spatiales et une temporelle, ou encore le calcul d'une fonction de corrélation du photon $i_{brut}$ avec ses voisins $vois(i_{brut})$ contenus dans une fenêtre spatio-temporelle $F_w(i_{brut})$ centrée autour du photon $i_{brut}$ et ayant la taille de fenêtre $\Delta T_w$ entrée à l'étape 202.

Puis dans une étape 208, un premier filtrage des photons pondérés à l'étape 206 est effectué en fonction des poids $W(i_{brut})$ affectés pour obtenir des photons filtrés $\underline{i}$.

Dans une étape 210, une image des photons filtrés $\underline{i}$ est construite à partir des photons filtrés $\underline{i}$ à l'étape 208 puis affichée. L'utilisateur est invité à indiquer s'il souhaite continuer le procédé de traitement 200 ou s'il souhaite modifier les paramètres de pondération.

Si l'utilisateur souhaite effectuer des modifications à la mise en oeuvre de l'étape de pondération 206, dans une étape 212 de modification, l'utilisateur choisit de nouveaux paramètres de pondération associés. Le procédé 200 se poursuit ensuite par le branchement en début de l'étape 206.

Si l'utilisateur ne souhaite pas de modification, le procédé 200 est poursuivi par une étape facultative d'affichage 214 d'histogramme des photons filtrés i par le premier filtrage de l'étape 208.

Dans l'étape d'affichage d'histogrammes 214, deux histogrammes sont créés pour une zone spatiale donnée, un premier histogramme représentant le nombre de photons filtrés $\underline{i}$ en fonction du temps, un deuxième histogramme représentant le poids $W(i)$ des photons filtrés $\underline{i}$ en fonction du temps. La zone spatiale a été déterminée au préalable par l'utilisateur qui a choisi les coordonnées du centre de la zone spatiale et la taille spatiale de la zone.

La mise en oeuvre du caractère optionnel de l'étape 214 est réalisée par une étape d'invitation préliminaire 216.

Ensuite, une étape facultative d'affichage 218 d'une vidéo des images des photons filtrés i ou bruts $i_{brut}$ ordonnées dans le temps est mise en oeuvre sur une demande effectuée dans une étape 220.

Dans l'étape d'affichage 218 de vidéo, une succession d'images est créée à partir de données réarrangées en sortie de l'étape 204 ou des données filtrées par le premier filtrage 208. La succession d'images correspond à une succession de séquences ou trames du cycle de fonctionnement du circuit. L'utilisateur a choisi au préalable la durée d'une séquence.

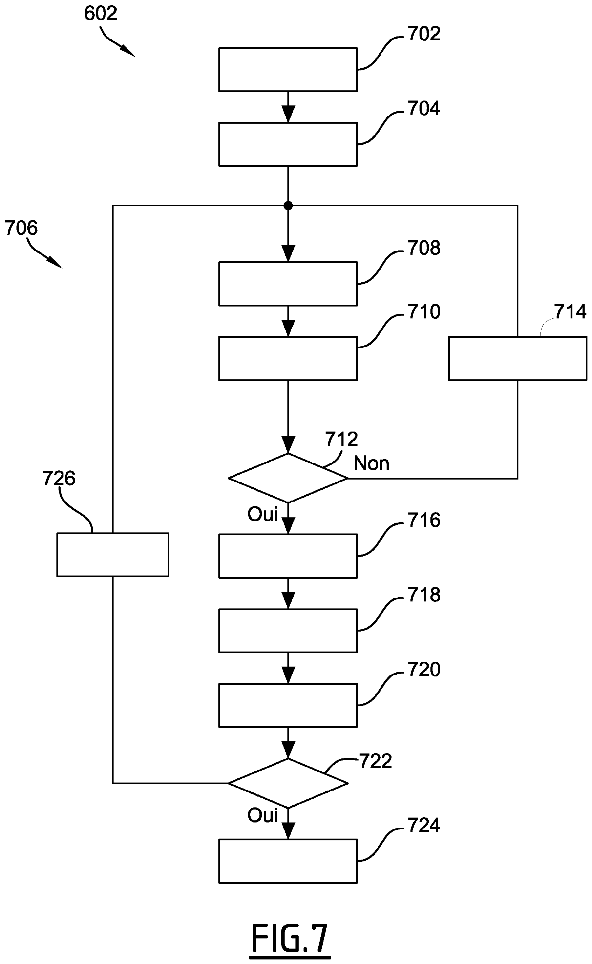

Puis, dans une étape de vectorisation 222, les photons filtrés i par le premier filtrage 208 des photons bruts et qui correspondent à un même évènement physique sont regroupés en un objet informationnel dit évènement ev(k) qui sera décrit ci-dessous dans la description de la Figure 7.

Un évènement physique est la commutation d'un transistor ou des commutations d'un groupe de transistors.

Une base de données, dite d'évènements, comprenant l'ensemble des évènements ev(k) en tant qu'objets informationnels est ainsi créée.

Un deuxième filtrage portant sur les évènements ev(k) est effectué au cours de l'étape de vectorisation 222.

Ensuite dans une étape de comparaison 224, deux bases de données d'évènements sont comparées.

Les deux bases d'évènements, une première et une deuxième, sont ici au travers du procédé de la figure 2 issues respectivement de deux acquisitions, une première acquisition de mesures effectuée sur un circuit électronique intégré pour lequel un ou des défauts sont recherchés, une deuxième acquisition de mesures effectuée sur un circuit électronique de référence connu comme étant en bon état de fonctionnement.

En variante, la deuxième base d'évènements issus de mesures effectuées sur un circuit de référence en bon état de fonctionnement est remplacée par une base d'évènements déduite au travers de l'étape de vectorisation d'une base de données contenant les résultats d'une simulation des photons émis par un circuit de référence en bon état de fonctionnement.

Dans une étape suivante 226, le ou les premiers évènements différents à l'origine possible du défaut sont identifiés.

Dans une étape 228, il est vérifié si le ou les premiers évènements différents correspondent de manière cohérente à la source de la défaillance et n'en sont pas seulement une conséquence directe, en raison d'un second filtrage trop limitatif effectué pendant l'étape de vectorisation 222 qui a pu enlever les véritables évènements à l'origine du défaut dans le circuit intégré.

Dans le cas ou un tel défaut de cohérence est suspecté, les paramètres du deuxième filtrage par exemple un seuil de filtrage Sev peuvent être modifiés dans une étape 230 par l'utilisateur.

Dans le cas d'une modification d'un paramètre de filtrage du deuxième filtrage de l'étape de vectorisation 222, les étapes 222, 224, 226, 228 sont répétées.

Dans le cas où la cohérence est vérifiée, le procédé 200 est terminé par une étape de terminaison 230.

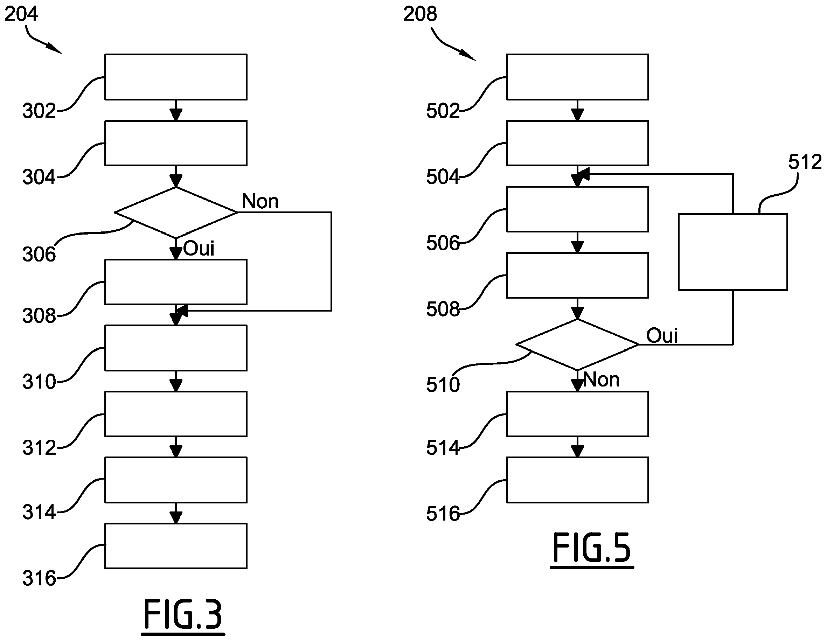

Suivant la Figure 3, l'étape 204 de traitement préliminaire des données de mesures $x(i_{acq})$, $y(i_{acq})$, $t(i_{acq})$ des photons détectés $i_{acq}$ comprend une succession d'étapes.

Dans une première étape 302, les photons $i_{acq}$, contenus dans la base de données des mesures, et paramétrés chacun de manière propre par les trois composantes spatio-temporelles $x(i_{acq})$, $y(i_{acq})$ et $t(i_{acq})$, qui apparaissent dans une bordure du détecteur 38, sont supprimés.

Par exemple, la bordure est déterminée par une marge de retrait 230 pixels autour de la périphérie de l'image supposée ici carrée et contenant 4094x4096 pixels.

Ensuite, dans une étape 304 un histogramme est affiché par l'unité de traitement 6. L'histogramme représente le nombre de photons détectés en fonction du temps.

Puis, dans une étape 306, l'utilisateur est invité à indiquer s'il souhaite réduire la période de travail sur le cycle de fonctionnement. Dans l'affirmative, l'utilisateur modifie la période de travail dans une étape 308 puis l'étape 306 est répétée.

Dans la négative, l'étape de traitement préliminaire 204 est poursuivie par une étape 310 dans laquelle les photons restants ($i_{brut}$) après le retrait de la bordure sont triés par ordre temporel.

Puis, dans une étape 312, afin de prendre en compte la sensibilité non uniforme du capteur optique 28, une matrice de correction étendue selon les coordonnées spatiales x et y, déterminée à partir d'une acquisition de mesures à vide c'est-à-dire sans circuit de test 24, est chargée dans le calculateur 60, et des sensibilités sont affectés à chaque photon $i_{brut}$, la sensibilité $S(i_{brut})$ étant égale à 1 lorsque le photon se trouve à un endroit du capteur dont la sensibilité est égale à une valeur médiane prédéterminée, la sensibilité $S(i_{brut})$ étant supérieure à 1 lorsque le photon est reçu en un endroit plus sensible par rapport à la valeur médiane, la sensibilité $S(i_{brut})$ étant inférieure à 1 lorsque le photon est reçu en un endroit moins sensible à la valeur médiane de sensibilité du capteur.

Ensuite, dans une étape 314, les données brutes associées à chaque photon $i_{brut}$, c'est-à-dire les coordonnées spatio-temporelles $x(i_{brut})$, $y(i_{brut})$, $t(i_{brut})$ de chaque photon et la sensibilité $S(i_{brut})$ associée du capteur optique en l'emplacement ($x(i_{brut})$, $y(i_{brut})$) sont enregistrés sous la forme d'un fichier binaire dans une base de données brutes.

Puis dans une étape 316, une image brute est créée à partir des données brutes de la base de données brutes. Au cours de l'étape 316, les coordonnées des photons $i_{brut}$ sont ajustées pour obtenir une superposition avec une image infrarouge dite LSM pour Laser Standard Masc servant de référence pour corriger le cas échéant un défaut d'alignement entre un plan optique de détection du détecteur et un plan du circuit électronique 24..

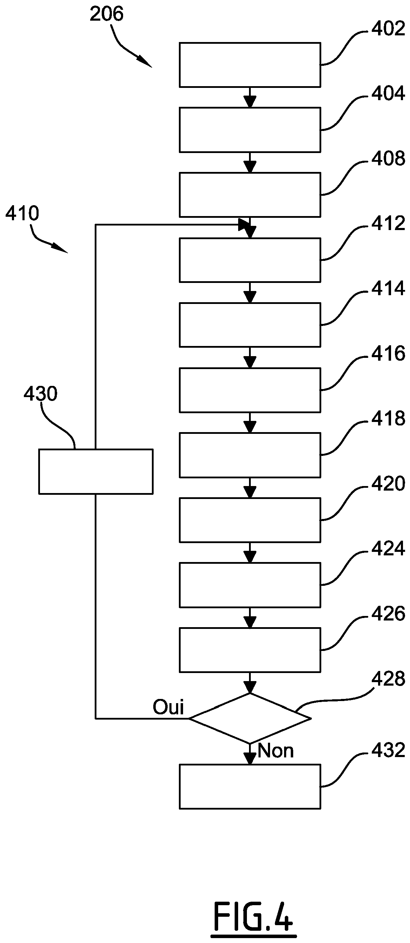

Suivant la figure 4, l'étape de pondération 206 des photons bruts $i_{brut}$, contenus dans la base des données brutes, ici la méthode STPC est décrite.

L'étape de pondération 206 comprend un ensemble d'étapes.

Dans une première étape 402, les données brutes obtenues après l'étape de traitement préliminaire 204 sont importées dans le calculateur 60. Les données brutes comprennent une liste des coordonnées spatio-temporelles des photons $i_{brut}$ et des sensibilités $S(i_{brut})$ du capteur 28 associées. Les photons bruts $i_{brut}$ sont classés par ordre temporel croissant.

Ensuite dans une étape 404, le nombre total nb de photons est compté.

Dans une étape suivante d'initialisation 408, deux variables imin et imax sont toutes deux mises égales à 1 et un compteur d'indice de photon $i_{brut}$ est mis égal à 1.

Puis une boucle 410 d'étapes est mise en oeuvre paramétrée par l'indice de photon désigné $i_{brut}$.

Dans une étape 412, les cordonnées spatio-temporelles $x(i_{brut})$, $y(i_{brut})$, $t(i_{brut})$ du photon brut d'indice $i_{brut}$ sont identifiées.

Puis dans une étape 414, le premier photon brut dont le temps est supérieur ou égal à $t(i_{brut})$-dt est recherché en parcourant la liste dans le sens des temps croissant, à partir du photon d'indice imin.

Dans une étape suivante 416, le paramètre imin est mis à jour en le mettant égal à l'indice du photon trouvé à l'étape 414.

Ensuite dans une étape 418, le dernier photon brut dont le temps est inférieur ou égal à $t(i_{brut})$+dt est recherché en parcourant la liste dans le sens des temps croissant, à partir du photon d'indice imax.

Dans une étape 420, le paramètre imax est mis a jour, en le mettant égal à l'indice du photon trouvé à l'étape 318.

Puis, dans une étape 422, les photons bruts dont l'indice est compris entre imin et imax sont récupérés, c'est-à-dire les photons situés dans la fenêtre temporelle [$t(i_{brut})$-dt ; $t(i_{brut})$+dt].

Ensuite dans une étape 424, parmi les photons récupérés à l'étape 422, les photons bruts qui sont en dehors de la fenêtre spatiale [$x(i_{brut})$-dl ; $x(i_{brut})$+dl] X [$y(i_{brut})$-dl ;$y(i_{brut})$+dl] X [$t(i_{brut})$-dl ;$t(i_{brut})$+dl] sont supprimés. Cette étape 424 est facilement et rapidement exécutable à l'aide de la fonction du logiciel Scilab, car la nouvelle liste de photons est beaucoup plus petite que celle de la base complète de données brutes.

Puis, dans une étape 426, un poids $W(i_{brut})$ du photon d'indice $i_{brut}$ est calculé comme étant égal à la somme des sensibilités du capteur associées aux photons restants de l'étape 424.

Dans l'étape suivante 428, il est vérifié si l'indice courant est inférieur strictement à nb.

Dans l'affirmative, l'indice courant $i_{brut}$ est incrémenté d'une unité par une étape 430, et les étapes 412, 414, 416, 418, 420, 422, 424, 426, 428 sont répétées avec l'indice i incrémenté.

Dans la négative, l'étape de pondération 206 des photons bruts est terminée par une étape de terminaison 432.

Suivant la figure 5, l'étape de premier filtrage 106 des photons pondérés comprend un ensemble d'étapes.

Dans une première étape 502, un histogramme est affiché représentant les poids de photons bruts pondérés en fonction du temps.

Puis, dans une étape 504, un seuil de premier filtrage $S_{filt}$ des photons bruts pondérés est choisi par l'utilisateur. De manière connexe, une valeur de seuil par défaut est calculée. La valeur de seuil par défaut correspond à une suppression de 80% des photons bruts. Elle sert de valeur indicative pour l'utilisateur.

Dans une étape suivante 506, les photons pondérés dont le poids est inférieur au seuil de premier filtrage $S_{filt}$ déterminé par l'utilisateur sont supprimés.

Ensuite dans une étape 508, un affichage d'une image des photons filtrés i résultant du premier filtrage 506 est fourni à l'utilisateur afin de le guider dans le choix d'une valeur de seuil de filtrage adapté.

Puis, dans une étape 510, l'utilisateur est invité à indiquer s'il souhaite modifier la valeur du seuil de filtrage $S_{filt}$.

Dans l'affirmative, le seuil de filtrage $S_{filt}$ est modifié dans une étape d'ajustement du seuil 512 et un branchement à l'étape 506 est effectué.

Le seuil $S_{filt}$ est ici ajustable par paliers en plus ou en moins de 2% ou 0,1% correspondant au pourcentage de suppression ou d'augmentation du nombre total de photons pondérés supprimés.

Dans la négative, l'étape 208 est poursuivie par l'exécution d'une étape 514 au cours de laquelle les données de filtrage correspondant à des photons filtrés sont enregistrés dans une base de données de photons filtrés.

Puis dans l'étape 516, une image des photons filtrés est crée à partir des données filtrées.

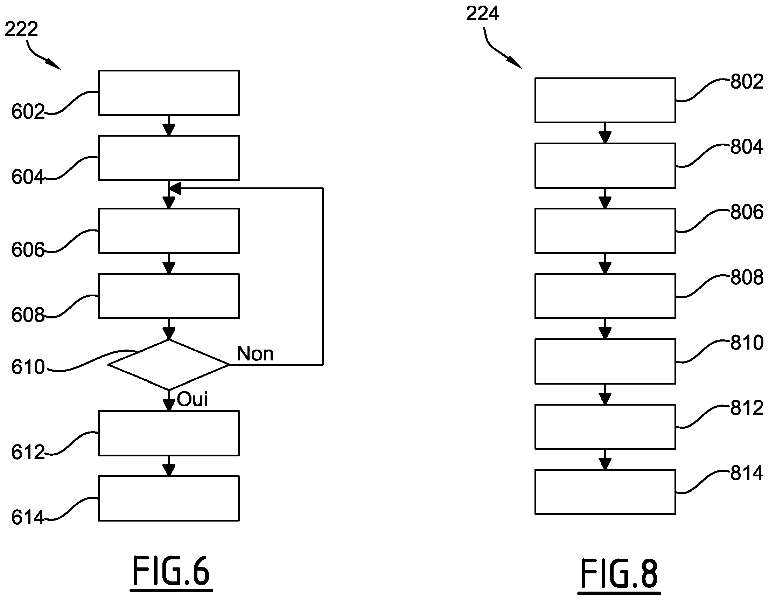

Suivant la figure 6, l'étape de vectorisation 222 comprend un ensemble d'étapes.

Dans une première étape 602, les photons filtrés i sont regroupés sous forme d'évènements, une taille spatio-temporelle maximale d'évènement ΔTmaxev sous la forme d'un triplet ($dl_{ev}$, $dl_{ev}$, $dt_{ev}$) ayant été au préalable déterminée par l'utilisateur. Pour chaque évènement déterminé ev(k), un poids d'évènement, des tailles maximale et minimale d'évènements sont déterminés en tant que composantes de l'évènement.

Dans une étape suivante 604, un histogramme est affiché représentant les poids des évènements en fonction du temps.

Puis dans une étape 606, un seuil d'un deuxième filtrage Sev portant sur les évènements est déterminé par l'utilisateur.

Ensuite dans une étape 608 un deuxième filtrage portant sur les évènements est effectué en supprimant les évènements dont le poids d'évènement associé est inférieur au seuil de deuxième filtrage Sev déterminé par l'utilisateur à l'étape 606.

Dans une étape suivante de vérification 610, il est vérifié si le nombre d'évènements observé est susceptible d'être correct au vu du nombre d'évènements physiques attendus.

Dans la négative, un branchement est effectué à l'étape 606.

Dans l'affirmative, l'étape de vectorisation 222 est poursuivi par une étape d'enregistrement 612 des données de type évènement dans une base de données d'évènements sous forme d'un fichier binaire.

Ensuite, dans une étape 614 une image des évènements est créée représentant les événements sous forme de carrés ayant une taille, une position et une couleur

La taille et la position de chaque carré est déterminée par les coordonnées spatiales minimum et maximum de l'évènement associé, et la couleur est fonction du poids de l'évènement.

Suivant la Figure 7, l'étape de regroupement 602 des photons filtrés i en évènements comprend un ensemble d'étapes.

Dans une première étape 702, les données filtrées i correspondant aux photons filtrés sont importés dans le calculateur 60 et comprennent une liste des coordonnées spatio-temporelles des photons filtrés $x(i)$, $y(i)$, $t(i)$ et de leurs poids associés $W(i)$. La liste en tant que structure de données comprend un pointeur de parcours des photons filtrés.

Dans une étape suivante 704, la taille spatio-temporelle d'un évènement $\Delta Tmaxev$ est choisie par l'utilisateur sous la forme la forme d'un triplet $(dl_{ev}, dl_{ev}, dt_{ev})$, dlev étant la composante spatiale de la taille de la fenêtre selon une quelconque coordonnée spatial xev et yev, dtev étant la composante temporelle de la fenêtre d'évènement. De plus, un pointeur d'indice courant de photon central k est mis égal à 1.

Puis, dans une boucle 706 d'étapes est mise en oeuvre paramétré par le pointeur d'indice de photon central k.

Dans une étape 708, les coordonnées spatio-temporelles du photon filtré central d'indice k sont identifiées en tant que $x(k)$, $y(k)$, $t(k)$.

Dans une étape suivante 710, les photons filtrés reg(k) qui sont à l'intérieur de la fenêtre spatio-temporelle Fev(k) ou $[x(k)-dlev, x(k)+dlev]$ x $[y(k)-dlev, y(k)+dlev]$ x $[t(k)-dtev, t(k)+dtev]$ encadrant le photon filtré d'indice k sont recherchés.

L'étape 710 est facilement et rapidement réalisée par exemple par la fonction find du logiciel Scilab du fait que la base de données des photons filtrés i est beaucoup plus petite que la base des données brutes.

Dans une étape suivante 712, il est vérifié si la fenêtre spatio-temporelle Fev(k) encadrant le photon central d'indice k comprend plus d'un photon filtré, le photon central d'indice k étant compris dans la fenêtre.

S'il n'existe qu'un photon isolé, dans une étape 714, le photon k est supprimé de la liste de travail, l'indice k courant est incrémenté d'une unité et l'étape de regroupement 602 est poursuivie par le branchement à l'étape 708.

S'il existe au moins un photon trouvé reg(k) à l'étape 710, alors dans une étape 716 d regroupement élémentaire un nouvel évènement ev(k) est créé dans la base de données des évènements structurée en liste. Le nouvel évènement comprend des caractéristiques associées telles qu'une position spatio-temporelle moyenne $P_{moy}(k)$, des coordonnées maximales et minimales des photons filtrés qui se trouvent à l'intérieur de la fenêtre Fev(k), et un poids d'évènement Wev(k) égal à la somme des poids des photons trouvés reg(k) dans la fenêtre spatio-temporelle et du poids $W(k)$ du photon central k.

La position spatio-temporelle moyenne $P_{moy}(k)$ est calculée par exemple comme une moyenne non pondérée c'est-à-dire un isobarycentre.

En variante, la position spatio-temporelle $P_{moy}(k)$ est calculée comme une moyenne pondérée des cordonnées des photons trouvés reg(k) et du photon k affectées des poids respectifs des photons $W(reg(k))$, $W(k)$.

Dans une étape suivante 718 les photons filtrés trouvés reg(k) et le photon k sont supprimés de la liste de travail des photons filtrés.

Puis dans une étape 720, l'indice le plus petit de la liste de travail est recherché.

Ensuite dans une étape 722, il est vérifié si la liste de travail est vide.

Dans l'affirmative, l'étape 602 est terminée par une étape de terminaison 724.

Sinon, dans une étape 726, l'indice trouvé dans l'étape 720 est affecté à l'indice courant k et un branchement est effectué en début d'étape 708.

Suivant la Figure 8, l'étape de comparaison 224 de deux bases de données d'évènements comprend une succession d'étapes.

Dans une première étape 802, les deux bases de données d'évènements, première et deuxième, issues des deux bases de données des mesures d'acquisition, sont importées dans le calculateur.

Désigné par nb1, le nombre total d'évènements contenus dans la première base de données est déterminé.

Désigné par nb2, le nombre total d'évènements contenus dans la deuxième base de données est déterminé.

Dans une étape suivante 804, les deux bases de données des mesures acquises correspondantes et de manière correspondante les deux bases de données d'évènements sont alignées spatialement entre elles par l'application d'une transformation homographique prédéterminée, la transformation homographique étant déterminée à partir de deux images LSM (dénomination anglaise de Laser Standard Masc) servant de marqueurs.

L'utilisateur marque chacune des deux images de quatre points rouges à des endroits identifiables du circuit électronique intégré.

En variante d'autres méthodes de détermination de la transformation homographique peuvent être utilisées.

Par exemple, des pointeurs lumineux sont utilisés pour pouvoir être identifié sur une image EMMI (dénomination anglaise de Emission Microscopy), ou encore la séquence de test électrique du circuit électronique est modifiée de façon à émettre en fonctionnement des éléments fonctionnels du circuit émettant de la lumière et dont la position est facilement repérable sur l'image EMMI.

Dans une étape suivante 806, une taille de fenêtre de tolérance $\Delta F_{comp}$, ici spatio-temporelle est déterminée avec une taille de la fenêtre égale au triplet ($dl_{com}$, $dl_{comp}$, $dt_{comp}$), $dl_{com}$, désignant la taille spatiale de la fenêtre de tolérance et $dt_{comp}$ désignant la taille temporelle de la fenêtre de tolérance. Dans la même étape 806, un indice courant d'évènement de parcours de boucle est désigné par $i_{comp}$ et mis égal à 1.

Dans une étape suivante 808, les évènements semblables sont déterminés par comparaison des deux bases de données d'évènements et sont supprimés.

Dans une étape 810, les évènements restants en sortie de l'étape 808 sont fusionnés dans une base de données d'évènements de diagnostic sous la forme d'un fichier binaire, une provenance de la base de données des évènements d'origine étant affecté à chaque événement.

Dans une étape suivante 812, une image est créée représentant les évènements sous forme de carrés avec une couleur associée et une luminosité associée. La taille et la position de chaque carré est déterminée par les coordonnées spatiales minimum et maximum de l'évènement associé. La couleur de l'évènement est fonction de son appartenance à l'une ou l'autre des bases de donnés d'évènements d'origine, et la luminosité de son poids.

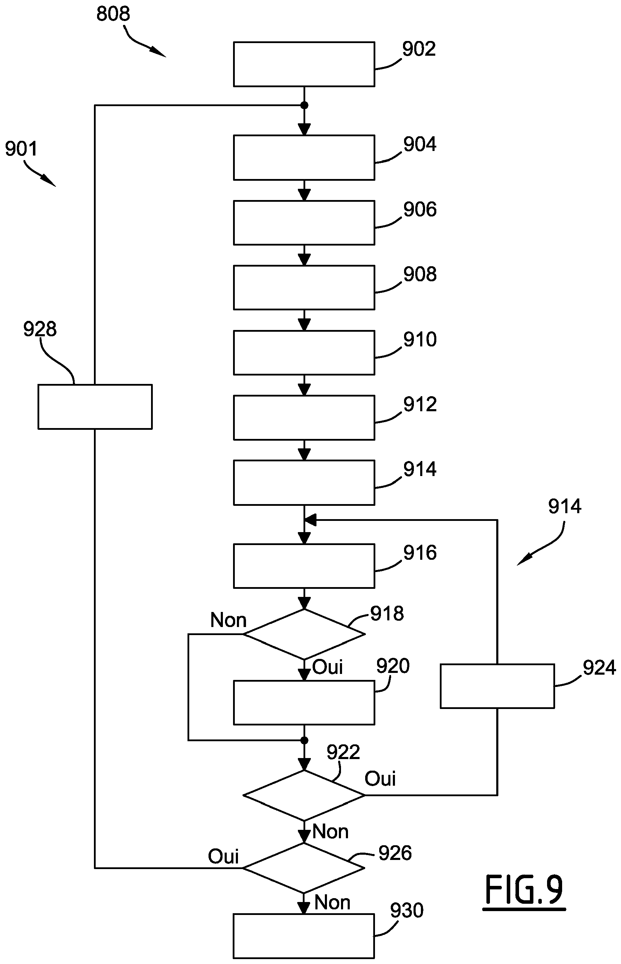

Suivant la figure 9, l'étape 808 est réalisée sous la forme d'une boucle 902 paramétrée par l'indice courant $i1_{comp}$ des évènements de la première base de données. La boucle 902 comprend un ensemble d'étapes.

L'indice courant $i1_{comp}$ est mis égal à 1 dans une étape 902.

Dans l'étape 904, les coordonnées spatio-temporelles $x(i1_{comp})$, $y(i1_{comp})$, $t(i1_{comp})$ de l'évènement courant noté $A(i1_{comp})$ de la première base de données sont identifiées.

Puis dans une étape 906, les évènements de la deuxième base de données d'évènements qui sont à l'intérieur de la fenêtre spatio-temporelle $[x(i1_{comp})-dl_{comp}, x(i1_{comp})+dl_{comp}] \times [y(i1_{comp})-dl_{comp}, y(i1_{comp})+dl_{comp}] \times [t(i1_{comp})-dt_{comp}, t(i1_{comp})+dt_{comp}]$ sont recherchés. Cette étape 906 est facilement réalisable avec la fonction find du logiciel Scilab du fait que la base de données des évènements est plus petite que la base des données de photons pondérés dont elle est issue.

Puis, il est vérifié dans l'étape 908 s'il existe au moins un évènement trouvé.

Dans le cas où il existe au moins un évènement trouvé, dans une étape 910, parmi les évènements trouvés, il est déterminé une liste des évènements trouvés et désignés par $A(i2_{trouv})$, situés à une distance minimale de $A(i1_{comp})$. $i2_{trouv}$ désignant le paramètre de parcours de cette liste et varie de 1 à $N_{trouv}$, $N_{trouv}$ étant égal au nombre total d'évènements trouvés dans la liste.

Dans une étape 912 un drapeau désigné par $\mu$ est mis égal à 0 et le paramètre $i2_{trouv}$ est mis égal à 1.

Puis une boucle 914 d'étapes est mise en oeuvre.

Dans l'étape 916, il est recherché dans la première base de données les évènements situés à une distance minimale de $A(2_{trouv})$.

Dans une étape 918, il est vérifié si $A(i1_{comp})$ fait partie des évènements trouvés à l'étape 916.

Si $A(i1_{comp})$ fait partie des évènements trouvés à l'étape 916, alors $A(i1_{comp})$ et $A(2_{trouv})$ sont considérés comme semblables et sont supprimés dans une étape 920 de leurs bases de données respectives. En même temps, le drapeau $\mu$ est mis égal à 1.

Dans le cas contraire, le drapeau $\mu$ reste égal à 0.

Puis dans une étape 922, il est vérifié si le drapeau est égal 0 et $i2_{trouv}$ est inférieur à $N_{trouv}$.

Dans l'affirmative, l'indice $i2_{trouv}$ est incrémentée d'une unité dans une étape d'incrémentation 924 et un branchement est effectué à l'étape de recherche 916.

Dans la négative, il est vérifié si $i1_{comp}$ est inférieur à nb1 dans une étape 926.

Si $i1_{comp}$ est inférieur à nb1, alors l'indice $i1_{comp}$ est incrémenté d'une unité dans une étape d'incrémentation 928 et l'étape de détermination d'évènements semblables est poursuivie par le branchement à l'étape 902.

A l'inverse, l'étape de détermination d'évènements semblables est terminée par une étape de terminaison 930.

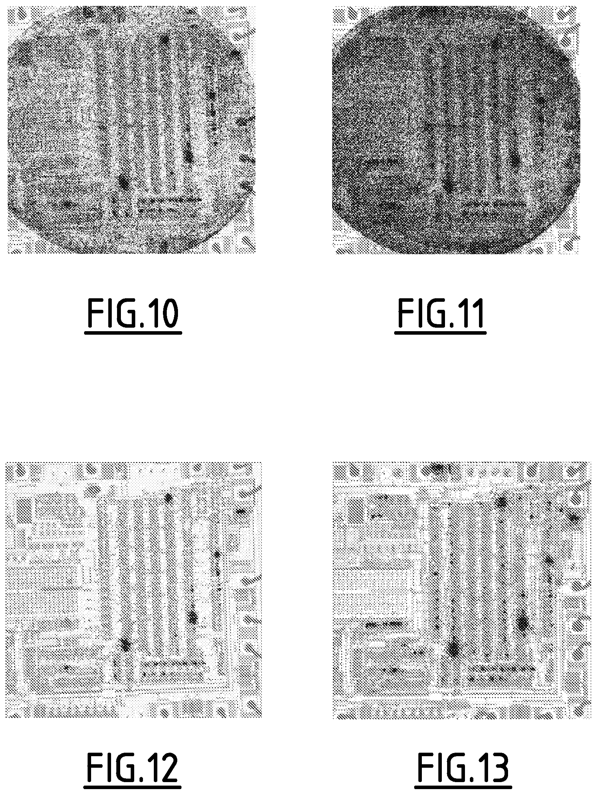

Les figures 10, 11, 12, 13, 14, 15, 16 17 se rapporte à un exemple d'application du procédé d'analyse de défauts à un circuit électronique dénommé MAX186.

Le circuit électronique MAX186 est un convertisseur analogique-numérique à 12 bits.

Au préalable des acquisitions en émission de photons ont été effectuées sur un circuit défectueux et un circuit en bon état de fonctionnement par le système PICA.

Les caractéristiques du circuit analysé et de l'acquisition des mesures sont rassemblées dans le tableau 1 ci-dessous.

**Tableau 1**

| Fréquence de fonctionnement | 20 MHz |
|---|---|
| Technologie | CMOS, 3 μm, 4 niveaux d'interconnexion |
| Zone active | 2,877 mm x 3,604 mm |
| Durée de la boucle d'acquisition | 250 ns |

Suivant les figures 10 et 11, les images respectives des circuits des photons bruts obtenus à l'issue de l'étape de traitement préliminaire sont représentées. L'image de la Figure 10 est celle du circuit défaillant tandis que celle de la Figure 11 est celle du circuit en bon état de marche.

Le tableau 2 ci-dessous résume les principales caractéristiques des images obtenues à la fin de l'étape de traitement préliminaire.

**Tableau 2**

| | Défaillant | Fonctionnel |
|---|---|---|
| Nombre de photons importés | 576512 | 603136 |
| Nombre de photons supprimés car dans la bordure du détecteur | 1128 | 1194 |
| Réduction de la période de travail | Sans | Sans |
| Nombre de photons restants | 575384 | 601942 |

Suivant les Figures 12 et 13, les images respectives des circuits des photons filtrés obtenus à l'issue de l'étape de filtrage des photons sont représentées. L'image de la Figure 12 est celle du circuit défaillant tandis que celle de la Figure 13 est celle du circuit en bon état de marche.

Le tableau 3 ci-dessous résume les principales caractéristiques des images obtenues à la fin de l'étape de traitement préliminaire.

**Tableau 3**

| | Défaillant | Fonctionnel |
|---|---|---|
| Technique de pondération | STPC | STPC |
| Taille spatiale de la fenêtre spatio-temporelle | 128 pixels | 128 pixels |
| Taille temporelle de la fenêtre spatio-temporelle | 50 ps | 50 ps |
| Seuil appliqué pour le filtrage | 7% | 7% |
| Nombre de photons restants après filtrage | 38624 | 38735 |

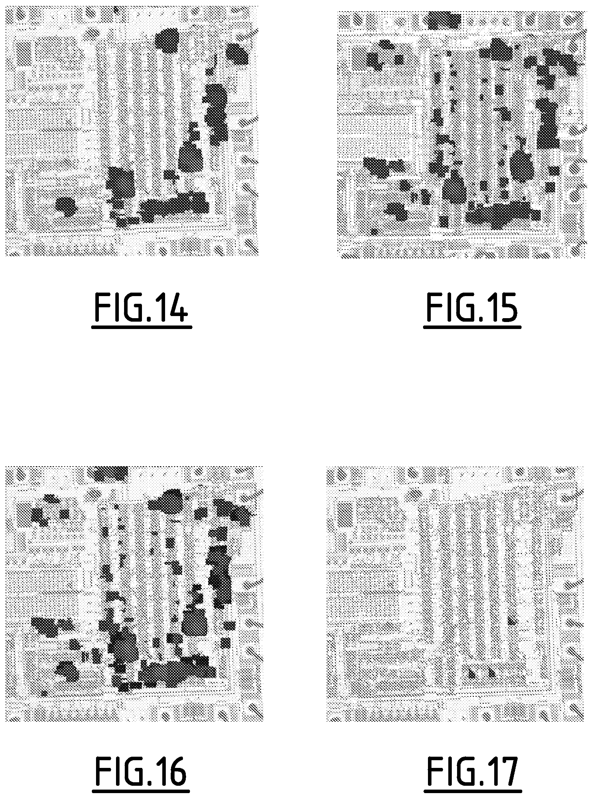

Suivant les Figures 14 et 15, les images respectives des évènements obtenus à l'issue de l'étape de vectorisation 222 sont représentées. L'image de la Figure 14 est celle du circuit défaillant tandis que celle de la Figure 15 est celle du circuit en bon état de marche.

Le tableau 4 ci-dessous résume les principales caractéristiques des images obtenues à la fin de l'étape de traitement préliminaire.

**Tableau 4**

| | Défaillant | Fonctionnel |
|---|---|---|
| Taille spatiale maximale d'un évènement | 64 pixels | 64 pixels |
| Taille temporelle maximale d'un évènement | 5000 ps | 5000 ps |
| Nombre d'évènements après regroupement | 2788 | 2899 |
| Seuil appliqué pour la sélection | 100 | 100 |
| Nombre d'évènements après filtrage | 994 | 984 |

Suivant la figure 16, les images respectives des figures 14 et 15 ont été superposés, les zones de recouvrement représentant des évènements semblables. Suivant la figure 17, seuls les premiers évènements divergents sont représentés, les évènements divergents postérieurs ayant été filtrés.

Le tableau 5 ci-dessous résume les principales caractéristiques des images obtenues à l'étape de comparaison.

**Tableau 5**

| | |
|---|---|
| Tolérance temporelle | 3000 ps |
| Tolérance spatiale | 4 pixels |
| Nombre d'évènements divergents | 1244 |
| Localisation temporelle du premier évènement divergent | 2851,4 ps |

En variante, le dispositif d'imagerie fournit des images de photons i caractérisés par les deux coordonnées spatiales x(i) et y(i), la durée d'une trame temporelle comme étant la durée d'une succession de séquences de test étant suffisamment longue pour détecter des photons sur une large étendue spatiale. Dans ce cas une corrélation purement spatiale des photons peut être effectuée.

Dans ce cas, l'étape de pondération des photons qualifiée de voisinage spatial requiert l'entrée par l'utilisateur d'une taille de fenêtre spatiale bidimensionnelle par exemple sous la forme (dl, dl), une trame temporelle $\Delta$trame suffisamment longue ayant été choisie pour avoir une forte probabilité de détecter un photon correspondant à un emplacement d'un composant défectueux. L'étape principale mise en oeuvre dans l'étape de pondération est le calcul d'un produit de convolution spatiale sur deux dimensions, c'est-à-dire une corrélation spatiale à deux dimensions de chaque photon détecté sur une fenêtre de taille (dl,dl).

En variante, le dispositif d'imagerie fournit des images de photons i caractérisés par une coordonnée temporelle seulement t(i), l'observation des photons étant limitée à une zone relativement étroite du circuit électronique. Cette limitation est réalisée par exemple à l'aide d'un masque opaque à la lumière émise par les composants du circuit situés en dehors de la zone et transparent au niveau de la zone étroite observée. Dans ce cas, une corrélation purement temporelle des photons émis est recherchée.

Dans ce cas, l'étape de pondération des photons qualifiés de voisinage temporelle requiert l'entrée par l'utilisateur d'une taille de fenêtre temporelle unidimensionnelle dt, la localisation de l'éventuel défaut recherché étant prédéterminée. L'étape principale mise en oeuvre dans l'étape de pondération est le calcul d'un produit de convolution temporelle unidimensionnelle, c'est-à-dire une corrélation temporelle à une dimension de chaque photon détecté étendu sur une fenêtre temporelle de taille dt.

De manière générale, un procédé de traitement d'image pour l'analyse de défauts d'un circuit électronique intégré est mis en oeuvre à partir d'une première base de données d'acquisition de mesures qui contient des données d'acquisition de mesure de photons isolés et détectés par un dispositif d'imagerie.

Le procédé comprend les étapes consistant à :

- déterminer à partir de la première base de données d'acquisition de mesures des photons isolés $i_{acq}$, une base de données de photons filtrés i contenant pour chaque photon filtré i un enregistrement qui comprend :
- une position P(i) spatiale et/ou temporelle du photon filtré i définie dans un repère spatial et/ou temporel à n dimensions, et
- un poids scalaire W(i) associé au photon filtré i.

Le procédé comprend au moins une étape de regroupement élémentaire de photons filtrés autour d'un photon filtré prédéterminé k central en un évènement ev(k), la ou chaque étape de regroupement élémentaire comprenant :

- la recherche autour du photon central k de position P(k) de photons reg(k) de positions respectives P(reg(k)) contenus dans une fenêtre spatiale et/ou temporelle Fev(k) d'évènement contenant P(k) et d'amplitude $\Delta$Tmaxev prédéterminée,
- lorsqu'au moins un photon reg(k) a été trouvé, le regroupement entre eux des photons trouvés dans la fenêtre Fev(k) en créant un évènement ev(k) associé au photon central k comme un enregistrement qui comprend :

  une position de l'évènement $P_{moy}$(k) égale à une première fonction des positions des photons k, Reg(k) contenus dans la fenêtre Fev(k),
  un poids d'évènement Wev(k) égal à une deuxième fonction des poids scalaires W(k), W(reg(k) de la totalité des photons contenus dans la fenêtre Fev(k).

En variante, l'enregistrement d'un évènement comprend également les coordonnées maximales et minimales des photons k, reg(k) contenus dans la fenêtre Fev(k).

En variante, la première fonction est une moyenne non pondérée des positions $P_{moy}(k)$ des photons k, reg(k) contenus dans la fenêtre Fev(k).

En variante, la première fonction est une moyenne pondérée des positions $P_{moy}(k)$ des photons k, reg(k) contenus dans la fenêtre Fev(k) affectés de leur poids scalaire respectif W(k), W(reg(k), de sorte que la position de l'évènement (ev(k)) est un barycentre des photons k, reg(k).

En variante, la deuxième fonction est la somme des poids W(k), W(reg(k) respectifs des photons k, reg(k) contenus dans la fenêtre Fev(k).

Le procédé comprend une phase de regroupement de tous les photons filtrés i de la première base de données en des évènements, la phase de regroupement consistant à appliquer l'étape de regroupement élémentaire à chaque photon i une seule fois, le photon i étant considéré soit comme un photon central, soit comme un photon trouvé dans une fenêtre d'évènement.

Les évènements créés ev(k) sont rassemblés dans une base de données ne contenant que des évènements.

Le procédé comprend une étape de filtrage des évènements ev(k) consistant à supprimer les évènements ev(k) dont le poids d'évènement Wev(k) est inférieur à une valeur de seuil prédéterminée Sev, les évènements restants étant des évènements filtrés ev($k_{filtre}$).

Le procédé comprend une étape de création d'une image des évènements filtrés, respectivement des évènements non filtrés ev(k), représentant le ou les évènements filtrés ev($k_{filtre}$), respectivement le ou les évènements non filtrés ev(k) sous la forme de segments, de carrés ou de volumes ayant chacun une position, une taille et une couleur, la taille et la position du segment, du carré ou du volume étant déterminée par les cordonnées de l'évènement filtré ev($k_{filtre}$), respectivement de l'évènement non filtré ev(k) et la couleur est fonction du poids Wev($k_{filtre}$) de l''évènement filtré, respectivement du poids Wev(k) de l'évènement non filtré ev(k).

Le procédé comprend une étape de comparaison d'au moins un évènement ev(k) déterminé à partir de la première base de données à au moins un évènement déterminé à partir d'une deuxième base de données dite de référence et correspondant à un circuit électronique identique en bon état de fonctionnement, et une étape d'identification des évènements non semblables dérivés respectivement de la première base de données et la deuxième base de données.

Le procédé comprend une étape de recueil de données d'acquisition de mesures de photons isolés $i_{acq}$ et détectés par un dispositif d'acquisition de mesures optiques, les données de mesures formant une image.

La position P(i) spatiale et/ou temporelle du photon filtré (i) est définie par n coordonnées $x_j(i)$ avec j entier variant de 1 à n, correspondant à un emplacement et/ou un moment d'émission du photon filtré i, les n coordonnées étant prises ensemble dans un n-uplet formé par n-1 coordonnées spatiales et une coordonnée temporelle t, les coordonnées spatiales étant définies par rapport à un repère spatial d'émission des photons du circuit électronique et la coordonnée temporelle t étant définie par rapport à une référence temporelle d'un signal électrique d'excitation du circuit électronique.

La taille maximale d'évènement ΔTmaxev est formée par un n-uplet $ΔTmaxev_j$, j entier variant de 1 à n, et

La fenêtre spatiale et/ou temporelle Fev(k) d'évènement est centrée autour de P(k) et d'amplitude ΔTmaxev

$$\prod_{j=1}^{n}\left[x_j(k) - \Delta T\max ev_j ; x_j(k) + \Delta T\max ev_j\right].$$

et s'écrit comme un ensemble produit cartésien

L'étape de détermination d'une base de données de photons filtrés i à partir de la première base de données d'acquisition de mesures des photons isolés comprend une étape d'arrangement préliminaire des donnés d'acquisition de mesures des photons mesurés $i_{acq}$ en des données brutes de photons bruts $i_{brut}$ et une étape de conversion des données brutes des photons bruts $i_{brut}$ en les données de photons filtrés i. Les données brutes contiennent pour chaque photon brut $i_{brut}$ un enregistrement qui comprend :

- une position P($i_{brut}$) spatiale et/ou temporelle du photon brut $i_{brut}$ définie dans un repère spatial et/ou temporel à n dimensions, et
- une valeur scalaire de sensibilité du capteur optique S($i_{brut}$) associée au photon brut ($i_{brut}$).

L'étape de conversion des données brutes des photons bruts $i_{brut}$ en les données de photons filtrés i comprend une étape de pondération de recherche autour du photon $i_{brut}$ de position P($i_{brut}$) de photons vois($i_{brut}$) de positions respectives P(vois($i_{brut}$)) contenus dans une fenêtre spatiale et/ou temporelle $F_W(i_{brut})$ de pondération de photon, la fenêtre de pondération de photon $F_W(i)$ contenant de P($i_{brut}$) et étant d'amplitude $ΔT_W$, et de calcul du poids (W($i_{brut}$)) associé au photon pondéré ($i_{brut}$) égal à une troisième fonction des sensibilités S(vois($i_{brut}$)) des photons ($i_{brut}$, vois($i_{brut}$)) trouvés dans la fenêtre $F_W(i_{brut})$.

La troisième fonction est en particulier la somme des sensibilités S(vois($i_{brut}$)) des photons $i_{brut}$, vois($i_{brut}$) trouvés dans la fenêtre $F_W(i_{brut})$.

L'tape de conversion des données brutes des photons bruts $i_{brut}$ en les données de photons filtres $\underline{i}$ comprend une étape de filtrage des photons bruts $i_{brut}$ pondérés succédant à l'étape de pondération consistant à supprimer les photons bruts pondérés dont le poids W($i_{brut}$) est inférieur à une valeur de seuil de filtrage de photons prédéterminée $S_{filt}$, es photons bruts pondérés restants constituant les photons filtrés i.

La position P($i_{brut}$) spatiale et/ou temporelle du photon filtré $\underline{i}$ est définie par n coordonnées $x_j(i_{brut})$ avec j entier variant de 1 à n, correspondant à un emplacement et/ou un moment d'émission du photon brut $i_{brut}$, les n coordonnées étant prises ensemble dans un n-uplet formé par n-1 coordonnées spatiales et une coordonnée temporelle $\underline{t}$, les coordonnées spatiales étant définies par rapport à un repère spatial d'émission des photons du circuit électronique et la coordonnée temporelle $\underline{t}$ étant définie par rapport à une référence temporelle d'un signal électrique d'excitation du circuit électronique. La taille de pondération de photon brut $\Delta T_W$ est formée par un n-uplet ($\Delta T_{Wj}$) et la fenêtre spatiale et/ou temporelle $F_W(i_{brut})$ est centrée autour de P($i_{brut}$) et d'amplitude $\Delta T_W$ et s'écrit comme un ensemble produit cartésien

$$\prod_{j=1}^{n}\left[x_j(i_{brut}) - \Delta T_{wj}\,;\,x_j(i_{brut}) + \Delta Tw_j\right].$$

Dans un premier cas particulier, le nombre n de dimensions d'acquisition est égal à 3 avec deux dimensions spatiales selon les coordonnées x, y et une dimension temporelle t, l'étape de pondération des photons est un procédé de corrélation spatio-temporelle STPC (Spatial Temporal Photo Correlation) avec la taille de la fenêtre de pondération $\Delta T_W$ formé par un triplet (dl, dl, dt) dans lequel les composantes spatiales de la taille de la fenêtre sont identiques.

Dans un deuxième cas particulier, le procédé utilise une technique d'acquisition comme l'émission de lumière statique, le nombre n de dimensions d'acquisition est égal à 2 avec deux dimensions spatiales selon les cordonnées x et y, l'étape de pondération des photons est un procédé de corrélation spatiale avec la taille de la fenêtre de pondération $\Delta T_W$ formé par un doublet (dl, dl) dans lequel les deux composantes spatiales de la taille de la fenêtre sont identiques.

Dans un troisième cas particulier, le procédé utilise une technique d'acquisition comme l'émission à résolution temporelle TRE (Time Resolved Emission) de lumière statique, le nombre n de dimensions d'acquisition est égal à 1 avec une unique dimension temporelle selon la coordonnée temporelle t, l'étape de pondération des photons est un procédé de corrélation temporelle avec la taille de la fenêtre de pondération $\Delta T_W$ formé par une valeur dt.

Ainsi, la qualité du filtrage des photons isolés détectés est améliorée par le second filtrage des objets informationnels constitués par les évènements.

En outre, les étapes subséquentes au deuxième filtrage portant sur les évènements présentent des durées plus petites et les bases de données sur lesquelles elles opèrent sont allégées.

## Revendications

1. Procédé de traitement d'image pour l'analyse de défauts d'un circuit électronique intégré (24), le procédé étant mis en oeuvre à partir d'une première base de données d'une image contenant des données d'acquisition de mesure de photons isolés et détectés par un dispositif d'acquisition de mesures optiques (4), comprenant les étapes consistant à

   - déterminer à partir de la première base de données d'acquisition de mesures des photons isolés ($i_{acq}$), une base de données de photons filtrés (i) contenant pour chaque photon filtré (i) un enregistrement qui comprend :
   - une position (P(i)) spatiale et/ou temporelle du photon filtré (i) définie dans un repère spatial et/ou temporel à n dimensions, et
   - un poids scalaire (W(i)) associé au photon filtré (i), procédé comprenant au moins une étape de regroupement élémentaire (716) de photons filtrés autour d'un photon filtré prédéterminé (k) central en un évènement (ev(k)), la ou chaque étape de regroupement élémentaire comprenant :

      - la recherche autour du photon central (k) de position (P(k)) de photons (reg(k)) de positions respectives (P(reg(k))) contenus dans une fenêtre spatiale et/ou temporelle (Fev(k)) d'évènement contenant (P(k)) et d'amplitude ($\Delta$Tmaxev) prédéterminée,
      - lorsqu'au moins un photon (P(reg(k))) a été trouvé, le regroupement entre eux des photons trouvés dans la fenêtre (Fev(k)) en créant un évènement ((ev(k))) associé au photon central (k) comme un enregistrement qui comprend :

une position de l'évènement ($P_{moy}(k)$) égale à une première fonction des positions des photons (k, Reg(k)) contenus dans la fenêtre (Fev(k)),

un poids d'évènement (Wev(k)) égal à une deuxième fonction des poids scalaires (W(k), W(reg(k)) de la totalité des photons contenus dans la fenêtre (Fev(k)),

le procédé étant **caractérisé en ce que** l'étape de détermination d'une base de données de photons filtrés (i) à partir de la base de données d'acquisition de mesures des photons isolés comprend une étape d'arrangement préliminaire (204) des donnés d'acquisition de mesures des photons mesurés ($i_{acq}$) en des données brutes de photons bruts ($i_{brut}$) et une étape de conversion (206, 208) des données brutes des photons bruts ($i_{brut}$) en les données de photons filtrés (i) ; **en ce que**

les données brutes contiennent pour chaque photon brut ($i_{brut}$) un enregistrement qui comprend :

- une position ($P(i_{brut})$) spatiale et/ou temporelle du photon brut ($i_{brut}$) définie dans un repère spatial et/ou temporel à n dimensions, et
- une valeur scalaire de sensibilité du capteur optique ($S(i_{brut})$) associée au photon brut ($i_{brut}$) ; et **en ce que**

l'étape de conversion (206, 208) des données brutes des photons bruts ($i_{brut}$) en les données de photons filtrés (i) comprend une étape de pondération (206) de recherche autour du photon ($i_{brut}$) de position ($P(i_{brut})$) de photons ($vois(i_{brut})$) de positions respectives ($P(vois(i_{brut}))$) contenus dans une fenêtre spatiale et/ou temporelle ($F_W(i_{brut})$) de pondération de photon, la fenêtre de pondération de photon ($F_W(i)$) contenant ($P(i_{brut})$) et étant d'amplitude ($\Delta T_W$), et de calcul du poids ($W(i_{brut})$) associé au photon pondéré ($i_{brut}$) égal à une troisième fonction des sensibilités ($S(vois(i_{brut}))$) des photons ($i_{brut}$, $vois(i_{brut})$) trouvés dans la fenêtre ($F_W(i_{brut})$).

2. Procédé de traitement d'image selon la revendication 1, **caractérisé en ce que** l'enregistrement d'un évènement comprend les coordonnées maximales et minimales des photons (k, reg(k)) contenus dans la fenêtre (Fev(k)).

3. Procédé de traitement d'image selon l'une quelconque des revendications 1 à 2, **caractérisé en ce que** la première fonction est une moyenne non pondérée des positions ($P_{moy}(k)$) des photons (k, reg(k)) contenus dans la fenêtre (Fev(k)).

4. Procédé de traitement d'image selon l'une quelconque des revendications 1 à 2, **caractérisé en ce que** la première fonction est une moyenne pondérée des positions ($P_{moy}(k)$) des photons (k,reg(k)) contenus dans la fenêtre (Fev(k)) affectés de leur poids scalaire respectif (W(k), W(reg(k)), de sorte que la position de l'évènement (ev(k)) est un barycentre des photons (k, reg(k)).

5. Procédé de traitement d'image selon l'une quelconque des revendications 1 à 4, **caractérisé en ce que** la deuxième fonction est la somme des poids (W(k), W(reg(k)) respectifs des photons (k, reg(k) contenus dans la fenêtre (Fev(k)).

6. Procédé de traitement d'image selon l'une quelconque des revendications 1 à 5, **caractérisé en ce qu'**il comprend une phase de regroupement (602) de tous les photons filtrés (i) de la base de données en des évènements, la phase de regroupement (602) consistant à appliquer l'étape de regroupement élémentaire à chaque photon (i) une seule fois, le photon (i) étant considéré soit comme un photon central, soit comme un photon trouvé dans une fenêtre d'évènement.

7. Procédé de traitement d'image selon la revendication 6, **caractérisé en ce que** les évènements créés (ev(k)) sont rassemblés dans une base de données ne contenant que des évènements.

8. Procédé de traitement d'image selon l'une quelconque des revendications 1 à 7, **caractérisé en ce qu'**il comprend une étape de filtrage (608) des évènements (ev(k)) consistant à supprimer les évènements (ev(k)) dont le poids d'évènement (Wev(k)) est inférieur à une valeur de seuil prédéterminée (Sev), les évènements restants étant des évènements filtrés ($ev(k_{filtre})$).

9. Procédé de traitement d'image selon l'une quelconque des revendications 1 à 6, **caractérisé en ce qu'**il comprend une étape de création d'une image des évènements filtrés (614), respectivement des évènements non filtrés (ev(k)), représentant le ou les évènements filtrés ($ev(k_{filtre})$),respectivement le ou les évènements non filtrés (ev(k)) sous la forme de segments, de carrés ou de volumes ayant chacun une position, une taille et une couleur, la taille et la position du segment, du carré ou du volume étant déterminée par les cordonnées de l'évènement filtré

(ev($k_{filtre}$)),respectivement de l'évènement non filtré (ev(k)) et la couleur est fonction du poids (Wev($k_{filtre}$)) de l"évènement filtré, respectivement du poids (Wev(k)) de l'évènement non filtré (ev(k)).

10. Procédé selon l'une quelconque des revendications 1 à 9, **caractérisé en ce qu'**il comprend une étape de comparaison (224) d'au moins un évènement (ev(k)) déterminé à partir de la première base de données à au moins un évènement déterminé à partir d'une deuxième base de données dite de référence et correspondant à un circuit électronique identique en bon état de fonctionnement, et une étape d'identification des évènements non semblables dérivés respectivement de la première base de données et la deuxième base de données.

11. Procédé selon l'une quelconque des revendications 1 à 10, **caractérisé en ce qu'**il comprend une étape de recueil de données d'acquisition de mesures de photons isolés ($i_{acq}$) et détectés par un dispositif d'acquisition de mesures optiques (4), les données de mesures formant une image.

12. Procédé de traitement d'image selon l'une quelconque des revendications 1 à 11, **caractérisé en ce que** la position (P(i)) spatiale et/ou temporelle du photon filtré (i) est définie par n coordonnées ($x_j$(i) avec j entier variant de 1 à n, correspondant à un emplacement et/ou un moment d'émission du photon filtré (i), les n coordonnées étant prises ensemble dans un n-uplet formé par n-1 coordonnées spatiales et une coordonnée temporelle (t), les coordonnées spatiales étant définies par rapport à un repère spatial d'émission des photons du circuit électronique et la coordonnée temporelle (t) étant définie par rapport à une référence temporelle d'un signal électrique d'excitation du circuit électronique,
la taille maximale d'évènement (ΔTmaxev) est formée par un n-uplet (ΔTmaxev$_j$), j entier variant de 1 à n, et
la fenêtre spatiale et/ou temporelle (Fev(k)) d'évènement est centrée autour de (P(k)) et d'amplitude (ΔTmaxev) et

$$\prod_{j=1}^{n}\left[x_j(k)-\Delta T\max ev_j; x_j(k)+\Delta T\max ev_j\right].$$

s'écrit comme un ensemble produit cartésien

13. Procédé de traitement d'image selon l'une quelconque des revendications 1 à 12, **caractérisé en ce que** la troisième fonction est la somme des sensibilités (S(vois($i_{brut}$))) des photons ($i_{brut}$, vois($i_{brut}$)) trouvés dans la fenêtre ($F_W$($i_{brut}$)).

14. Procédé selon l'une quelconque des revendications 1 à 13, **caractérisé en ce que** l'étape de conversion (206, 208) des données brutes des photons bruts ($i_{brut}$) en les données de photons filtres (i) comprend une étape de filtrage (208) des photons bruts ($i_{brut}$) pondérés succédant à l'étape de pondération (206) consistant à supprimer les photons bruts pondérés dont le poids (W($i_{brut}$)) est inférieur à une valeur de seuil de filtrage de photons prédéterminée ($S_{filt}$), les photons bruts pondérés restants constituant les photons filtrés (i).

15. Procédé de traitement d'image selon l'une quelconque des revendications 1 à 14, **caractérisé en ce que** la position (P($i_{brut}$)) spatiale et/ou temporelle du photon filtré (i) est définie par n coordonnées ($x_j$($i_{brut}$) avec j entier variant de 1 à n, correspondant à un emplacement et/ou un moment d'émission du photon brut ($i_{brut}$), les n coordonnées étant prises ensemble dans un n-uplet formé par n-1 coordonnées spatiales et une coordonnée temporelle (t), les coordonnées spatiales étant définies par rapport à un repère spatial d'émission des photons du circuit électronique et la coordonnée temporelle (t) étant définie par rapport à une référence temporelle d'un signal électrique d'excitation du circuit électronique,
la taille de pondération de photon brut (Δ$T_W$) est formée par un n-uplet (Δ$T_{Wj}$), et
la fenêtre spatiale et/ou temporelle ($F_W$($i_{brut}$)) est centrée autour de (P($i_{brut}$)) et d'amplitude (Δ$T_W$) et s'écrit comme

$$\prod_{j=1}^{n}\left[x_j(i_{brut})-\Delta T_{wj}; x_j(i_{brut})+\Delta Tw_j\right],$$

un ensemble produit cartésien                                                    et

16. Procédé selon l'une quelconque des revendications 1 à 15, **caractérisé en ce que** n est un entier inférieur ou égal à 3 et **en ce que** les coordonnées ($x_j$(i) d'un photon filtré (i), respectivement ($x_j$($i_{brut}$) d'un photon brut ($i_{brut}$) avec j entier variant de 1 à 3, correspondent à un emplacement et/ou un moment d'émission du photon filtré (i) respectivement du photon ($i_{brut}$), les n coordonnées étant prises ensemble dans un triplet formé par une première coordonnée spatiale (x), une deuxième coordonnée spatiale (y) et une coordonnée temporelle (t), les coordonnées spatiales (x) et (y) étant définies par rapport à un repère spatial d'un plan d'émission des photons du circuit électronique et la coordonnée temporelle (t) étant définie par rapport à une référence temporelle d'un signal électrique d'excitation du circuit électronique.

**17.** Procédé selon l'une quelconque de revendications 1 à 16, **caractérisé en ce que** le nombre n de dimensions d'acquisition est égal à 3 avec deux dimensions spatiales selon les coordonnées (x), (y) et une dimension temporelle t, l'étape de pondération des photons est un procédé de corrélation spatio-temporelle STPC (Spatial Temporal Photo Correlation) avec la taille de la fenêtre de pondération ($\Delta T_W$) formé par un triplet (dl, dl, dt) dans lequel les composantes spatiales de la taille ($\Delta T_W$) de la fenêtre sont identiques.

**18.** Procédé selon l'une quelconque des revendications 1 à 16, **caractérisé en ce que** le procédé utilise une technique d'acquisition comme l'émission de lumière statique, le nombre $\underline{n}$ de dimensions d'acquisition est égal à 2 avec deux dimensions spatiales selon les cordonnées (x) et (y), l'étape de pondération des photons (206) est un procédé de corrélation spatiale avec la taille de la fenêtre de pondération ($\Delta T_W$) formé par un doublet (dl, dl) dans lequel les deux composantes spatiales de la taille de la fenêtre sont identiques.

**19.** Procédé selon l'une quelconque des revendications 1 à 16, **caractérisé en ce que** le procédé utilise une technique d'acquisition comme l'émission à résolution temporelle TRE (Time Resolved Emission) de lumière statique, le nombre $\underline{n}$ de dimensions d'acquisition est égal à 1 avec une unique dimension temporelle selon la coordonnée temporelle (t), l'étape de pondération des photons (206) est un procédé de corrélation temporelle avec la taille de la fenêtre de pondération ($\Delta T_W$) formé par une valeur (dt).

**20.** Produit programme d'ordinateur comprenant des instructions de programme pour mettre en oeuvre les étapes du procédé selon l'une quelconque des revendications 1 à 19 lorsque ledit programme fonctionne sur un ordinateur (60).

**21.** Système pour l'analyse de défauts d'un circuit électronique intégré comprenant
un dispositif d'acquisition de mesures optiques apte (4) à détecter des photons isolés émis par le circuit électronique et à fournir des données d'acquisition de mesure des photons isolés détectés ($i_{acq}$),
une mémoire (62) apte à sauvegarder les données d'acquisition de mesure des photons isolés détectés formant une base de données,
un calculateur (60) apte à déterminer à partir de la base de données d'acquisition de mesures des photons isolés une base de données de photons filtrés (i) contenant pour chaque photon filtré (i) un enregistrement qui comprend :

- une position P(i) spatiale et/ou temporelle du photon filtré (i) définie dans un repère spatial et/ou temporel à n dimensions, avec n entier inférieur ou égal à 3, par n coordonnées ($x_j$(i) avec j entier variant de 1 à n, correspondant à un emplacement et/ou un moment d'émission du photon filtré (i), les n coordonnées étant prises ensemble dans un triplet formé par une première coordonnée spatiale (x), une deuxième cordonnée spatiale (y) et une coordonnée temporelle (t), les coordonnées spatiales (x) et (y) étant définies par rapport à un repère spatial d'un plan d'émission des photons du circuit électronique et la coordonnée temporelle (t) étant définie par rapport à une référence temporelle d'un signal électrique d'excitation du circuit électronique, et
- un poids scalaire (W(i)) associé au photon filtré (i), le calculateur (60) étant apte à mettre en oeuvre une étape de regroupement élémentaire de photons autour d'un photon prédéterminé (k) central en un événement (ev(k)), l'étape de regroupement élémentaire consistant à :

- une taille maximale d'événement ($\Delta T maxev$) formée par un n-uplet ($\Delta T maxev_j$) étant prédéterminée, rechercher autour du photon prédéterminé (k) de position (P(k)) les photons (reg(k)) de positions respectives (P(reg(k))) contenus dans une fenêtre spatiale et/ou temporelle (Fev(k)) d'évènement, la fenêtre d'évènement (Fev(k)) étant centrée autour de (P(k)) et d'amplitude ($\Delta T maxev$) et s'écrivant comme ensemble

$$\prod_{j=1}^{n}\left[x_j(k) - \Delta T \max ev_j ; x_j(k) + \Delta T \max ev_j\right],$$
produit
- lorsqu'au moins un photon (reg(k)) a été trouvé, regrouper entre eux les photons trouvés dans la fenêtre (Fev(k)) en créant un événement (ev(k)) associé au photon (k) comme un enregistrement qui comprend :

une position de l'événement égal à la moyenne ($P_{moy}$(k)) des positions des photons (reg(k)) contenus dans la fenêtre (Fev(k)) et du photon (k),
les coordonnées maximales et minimales des photons contenus dans la fenêtre (Fev(k)), le photon (k) y compris,

un poids d'évènement (Wev(k)) égal à la somme des poids de la totalité des photons contenus dans la fenêtre (Fev(k)),

le système étant **caractérisé en ce que** le calculateur (60) est apte à mettre en oeuvre dans l'étape de détermination d'une base de données de photons filtrés une étape d'arrangement préliminaire (204) des données d'acquisition de mesures des photons mesurés ($i_{acq}$) en des données brutes de photons bruts ($i_{brut}$) et une étape de conversion (206, 208) des données brutes des photons bruts ($i_{brut}$) en les données de photons filtrés (i) ;

**en ce que** les données brutes contiennent pour chaque photon brut ($i_{brut}$) un enregistrement qui comprend :

- une position ($P(i_{brut})$) spatiale et/ou temporelle du photon brut ($i_{brut}$) définie dans un repère spatial et/ou temporel à n dimensions, et
- une valeur scalaire de sensibilité du capteur optique ($S(i_{brut})$) associée au photon brut ($i_{brut}$) ;

et **en ce que** le calculateur (60) est propre à mettre en oeuvre dans l'étape de conversion une étape de pondération (206) de recherche autour du photon ($i_{brut}$) de position ($P(i_{brut})$) de photons ($vois(i_{brut})$) de positions respectives ($P(vois(i_{brut}))$) contenus dans une fenêtre spatiale et/ou temporelle ($F_W(i_{brut})$) de pondération de photon, la fenêtre de pondération de photon ($F'_W(i)$) contenant ($P(i_{brut})$) et étant d'amplitude ($\Delta T_W$), et de calcul du poids ($W(i_{brut})$) associé au photon pondéré ($i_{brut}$) égal à une troisième fonction des sensibilités ($S(vois(i_{brut}))$) des photons ($i_{brut}$, $vois(i_{brut})$) trouvés dans la fenêtre ($F_W(i_{brut})$).

## Patentansprüche

1. Bildverarbeitungsverfahren zur Fehleranalyse einer integrierten elektronischen Schaltung (24), wobei das Verfahren ausgehend von einer ersten Datenbank eines Bildes umgesetzt wird, die Aufnahmedaten einer Messung isolierter und von einer optischen Messaufnahmevorrichtung (4) erfasster Photonen enthält, die Schritte aufweisend, die darin bestehen,

   - ausgehend von der ersten Datenbank zur Aufnahme von Messungen der isolierten Photonen ($i_{acq}$) eine Datenbank von gefilterten Photonen (i) zu bestimmen, die für jedes gefilterte Photon (i) eine Speicherung enthält, die umfasst:

     - eine räumliche und/ oder zeitliche Position (P(i)) des gefilterten Photons (i), die in einer räumlichen und/ oder zeitlichen Markierung mit n Dimensionen definiert ist, und
     - ein skalares Gewicht (W(i)), das dem gefilterten Photon (i) zugeordnet ist,

   wobei das Verfahren mindestens einen Schritt zur elementaren Zusammenführung (716) der gefilterten Photonen um ein zentrales vorbestimmtes gefiltertes Photon (k) in einem Ereignis (ev(k)) umfasst, wobei der oder jeder Schritt zur elementaren Zusammenführung umfasst:

     - die Suche um das zentrale Photon (k) einer Position (P(k)) nach Photonen (reg(k)) jeweiliger Positionen (P(reg(k))), die in einem räumlichen und/ oder zeitlichen Fenster (Fev(k)) eines enthaltenden Ereignisses (P(k)) und mit einer vorbestimmten Amplitude ($\Delta$Tmaxev) enthalten sind,
     - wenn mindestens ein Photon (P(reg(k))) gefunden wurde, die Zusammenführung untereinander der gefundenen Photonen in dem Fenster (Fev(k)) durch Erstellen eines Ereignisses (ev(k)), das dem zentralen Photon (k) als Speicherung zugeordnet ist, die umfasst:

       eine Position des Ereignisses ($P_{moy}(k)$) gleich einer ersten Funktion der Positionen der Photonen (k, Reg(k)), die in dem Fenster (Fev(k)) enthalten sind,
       ein Ereignisgewicht (Wev(k)) gleich einer zweiten Funktion der skalaren Gewichte (W(k), W(reg(k))) der Gesamtheit der Photonen, die in dem Fenster (Fev(k)) enthalten sind,
       wobei das Verfahren **dadurch gekennzeichnet ist, dass** der Schritt einer Bestimmung einer Datenbank von gefilterten Photonen (i) ausgehend von der Datenbank zur Aufnahme von Messungen der isolierten Photonen einen Schritt zum vorherigen Anordnen (204) der Aufnahmedaten von Messungen der gemessenen Photonen ($i_{acq}$) in Rohdaten von rohen Photonen ($i_{brut}$) und einen Schritt zum Umwandeln (206, 208) der Rohdaten von rohen Photonen ($i_{brut}$) in die Daten von gefilterten Photonen (i) umfasst; dadurch, dass

die Rohdaten für jedes rohe Photon ($i_{brut}$) eine Speicherung enthalten, die umfasst:

- eine räumliche und/ oder zeitliche Position ($P(i_{brut})$) des rohen Photons ($i_{brut}$), die in einer räumlichen und/ oder zeitlichen Markierung mit $\underline{n}$ Dimensionen definiert ist, und
- einen skalaren Empfindlichkeitswert des optischen Sensors ($S(i_{brut})$), der dem rohen Photon ($i_{brut}$) zugeordnet ist; und dadurch, dass der Schritt zum Umwandeln (206, 208) der Rohdaten der rohen Photonen ($i_{brut}$) in die Daten von gefilterten Photonen ($i$) einen Gewichtungsschritt (206) zur Suche um das Photon ($i_{brut}$) einer Position ($P(i_{brut})$) von Photonen ($vois(i_{brut})$) jeweiliger Positionen ($P(vois(i_{brut}))$) umfasst, die in einem räumlichen und/ oder zeitlichen Gewichtungsfenster ($Fw(i_{brut})$) eines Photons enthalten sind, wobei das Gewichtungsfenster eines Photons ($Fw(i)$) ($P(i_{brut})$) enthält und eine Amplitude ($\Delta T_w$) aufweist, und zur Berechnung des Gewichts ($W(i_{brut})$), das dem gewichteten Photon ($i_{brut}$) zugeordnet ist, gleich einer dritten Funktion der Empfindlichkeiten ($S(vois(i_{brut}))$) der Photonen ($i_{brut}$, $vois(i_{brut})$), die im Fenster ($Fw(i_{brut})$) gefunden wurden.

2.  Bildverarbeitungsverfahren nach Anspruch 1, **dadurch gekennzeichnet, dass** die Speicherung eines Ereignisses die maximalen und die minimalen Koordinaten der Photonen ($k$, $reg(k)$) umfasst, die in dem Fenster ($Fev(k)$) enthalten sind.

3.  Bildverarbeitungsverfahren nach einem der Ansprüche 1 bis 2, **dadurch gekennzeichnet, dass** die erste Funktion ein nicht gewichteter Mittelwert der Positionen ($P_{moy}(k)$) der Photonen ($k$, $reg(k)$) ist, die in dem Fenster ($Fev(k)$) enthalten sind.

4.  Bildverarbeitungsverfahren nach einem der Ansprüche 1 bis 2, **dadurch gekennzeichnet, dass** die erste Funktion ein gewichteter Mittelwert der Positionen ($P_{moy}(k)$) der Photonen ($k$, $reg(k)$) ist, die in dem Fenster ($Fev(k)$) enthalten sind, die aus ihrem jeweiligen skalaren Gewicht ($W(k)$, $W(reg(k))$) zugeordnet sind, sodass die Position des Ereignisses ($ev(k)$) ein Baryzentrum der Photonen ($k$, $reg(k)$) ist.

5.  Verfahren zur Bildverarbeitung nach einem der Ansprüche 1 bis 4, **dadurch gekennzeichnet, dass** die zweite Funktion die Summe der jeweiligen Gewichte ($W(k)$, $W(reg(k))$) der Photonen ($k$, $reg(k)$ ist, die in dem Fenster ($Fev(k)$) enthalten sind.

6.  Bildverarbeitungsverfahren nach einem der Ansprüche 1 bis 5, **dadurch gekennzeichnet, dass** es eine Zusammenführungsphase (602) aller gefilterten Photonen ($i$) der Datenbank in Ereignisse umfasst, wobei die Zusammenführungsphase (602) darin besteht, den Schritt zur elementaren Zusammenführung auf jedes Photon ($i$) ein einziges Mal anzuwenden, wobei das Photon ($i$) entweder als zentrales Photon, oder als ein Photon angesehen wird, das in einem Ereignisfenster gefunden wurde.

7.  Bildverarbeitungsverfahren nach Anspruch 6, **dadurch gekennzeichnet, dass** die erstellten Ereignisse ($ev(k)$) in einer Datenbank zusammengeführt werden, die nur Ereignisse enthält.

8.  Bildverarbeitungsverfahren nach einem der Ansprüche 1 bis 7, **dadurch gekennzeichnet, dass** es einen Filterschritt (608) der Ereignisse ($ev(k)$) umfasst, der darin besteht, die Ereignisse ($ev(k)$) zu löschen, deren Ereignisgewicht ($Wev(k)$) kleiner als ein vorbestimmter Grenzwert ($Sev$) ist, wobei die verbleibenden Ereignisse gefilterte Ereignisse ($ev(k_{filtre})$) sind.

9.  Bildverarbeitungsverfahren nach einem der Ansprüche 1 bis 6, **dadurch gekennzeichnet, dass** es einen Schritt zur Erstellung eines Bildes der gefilterten Ereignisse (614), beziehungsweise der nicht gefilterten Ereignisse ($ev(k)$) umfasst, welches das oder die gefilterten Ereignisse ($ev(k_{filtre})$), beziehungsweise das oder die nicht gefilterten Ereignisse ($ev(k)$) in Form von Segmenten, von Quadraten oder Volumina repräsentiert, die jeweils eine Position, eine Größe und eine Farbe aufweisen, wobei die Größe und die Position des Segments, des Quadrats oder des Volumens durch die Koordinaten des gefilterten Ereignisses ($ev(k_{filtre})$) beziehungsweise des nicht gefilterten Ereignisses ($ev(k)$) bestimmt werden, und die Farbe von dem Gewicht ($Wev(k_{filtre})$) des gefilterten Ereignisses beziehungsweise von dem Gewicht ($Wev(k)$) des nicht gefilterten Ereignisses ($ev(k)$) abhängt.

10. Verfahren nach einem der Ansprüche 1 bis 9, **dadurch gekennzeichnet, dass** es einen Schritt zum Vergleichen (224) mindestens eines bestimmten Ereignisses ($ev(k)$) ausgehend von der ersten Datenbank mit zumindest einem bestimmten Ereignis ausgehend von einer zweiten Datenbank, die Referenzdatenbank genannt wird, und einer identischen elektronischen Schaltung in korrektem Betriebszustand entspricht, und einen Schritt zum Identifizieren der nicht ähnlichen Ereignisse, die jeweils aus der ersten Datenbank und aus der zweiten Datenbank abgeleitet werden.

11. Verfahren nach einem der Ansprüche 1 bis 10, **dadurch gekennzeichnet, dass** es einen Schritt zum Sammeln von Aufnahmedaten von Messungen isolierter und von einer optischen Messaufnahmevorrichtung (4) erfasster Photonen ($i_{acq}$) umfasst, wobei die Messdaten ein Bild bilden.

12. Bildverarbeitungsverfahren nach einem der Ansprüche 1 bis 11, **dadurch gekennzeichnet, dass**
die räumliche und/ oder zeitliche Position (P(i)) des gefilterten Photons (i) durch n Koordinaten ($x_j(i)$) definiert wird, wobei j eine Ganzzahl ist, die von 1 bis n variiert, entsprechend einer Stelle und/ oder einem Zeitpunkt der Emission des gefilterten Photons (i), wobei die n Koordinaten in einem n-Tupel zusammengenommen sind, das durch n-1 räumliche Koordinaten und eine zeitliche Koordinate (t) gebildet wird, wobei die räumlichen Koordinaten im Verhältnis zu einer räumlichen Emissionsmarkierung der Photonen der elektronischen Schaltung definiert sind und die zeitliche Koordinate (t) im Verhältnis zu einer zeitlichen Referenz eines elektronischen Anregungssignals der elektronischen Schaltung definiert wird,
die maximale Ereignisgröße (ΔTmaxev) durch ein n-Tupel ($\Delta Tmaxev_j$) gebildet wird, wobei j eine Ganzzahl ist, die von 1 bis n variiert, und
das räumliche und/ oder zeitliche Ereignisfenster (Fev(k)) um (P(k)) und Amplitude (ΔTmaxev) herum zentriert ist und wie eine kartesische Produkteinheit geschrieben wird

$$\prod_{j=1}^{n}\left[x_j(k) - \Delta T \max ev_j ; x_j(k) + \Delta T \max ev_j\right]$$

.

13. Bildverarbeitungsverfahren nach einem der Ansprüche 1 bis 12, **dadurch gekennzeichnet, dass** die dritte Funktion die Summe der Empfindlichkeiten ($S(vois(i_{brut}))$) der Photonen ($i_{brut}$, $vois(i_{brut})$) ist, die in dem Fenster ($F_w(i_{brut})$) gefunden wurden.

14. Verfahren nach einem der Ansprüche 1 bis 13, **dadurch gekennzeichnet, dass** der Schritt zum Umwandeln (206, 208) der Rohdaten der rohen Photonen ($i_{brut}$) in die Daten von Filterphotonen (i) einen Filterschritt (208) der gewichteten rohen Photonen ($i_{brut}$) umfasst, der auf den Gewichtungsschritt (206) folgt, der darin besteht, die gewichteten rohen Photonen zu löschen, deren Gewicht ($W(i_{brut})$) kleiner als ein vorbestimmter Filtergrenzwert von Photonen ($S_{filt}$) ist, wobei die bleibenden gewichteten Photonen die gefilterten Photonen (i) bilden.

15. Bildverarbeitungsverfahren nach einem der Ansprüche 1 bis 14, **dadurch gekennzeichnet, dass**
die räumliche und/ oder zeitliche Position ($P(i_{brut})$) des gefilterten Photons (i) durch n Koordinaten ($x_j(i_{brut})$) definiert wird, wobei j eine Ganzzahl ist, die von 1 bis n variiert, entsprechend einer Stelle und/ oder einem Zeitpunkt der Emission des rohen Photons ($i_{brut}$), wobei die n Koordinaten in einem n-Tupel zusammengenommen sind, das durch n-1 räumliche Koordinaten und eine zeitliche Koordinate (t) gebildet wird, wobei die räumlichen Koordinaten im Verhältnis zu einer räumlichen Emissionsmarkierung der Photonen der elektronischen Schaltung definiert sind und die zeitliche Koordinate (t) im Verhältnis zu einer zeitlichen Referenz eines elektronischen Anregungssignals der elektronischen Schaltung definiert wird,
die Gewichtungsgröße des rohen Photons (ΔTw) durch ein n-Tupel ($\Delta Tw_j$) gebildet wird, und
das räumliche und/ oder zeitliche Ereignisfenster ($Fw(i_{brut})$) um ($P(i_{brut})$) herum zentriert ist und die Amplitude (ΔTw)

$$\prod_{j=1}^{n}\left[x_j(i_{brut}) - \Delta T_{wj} ; x_j(i_{brut}) + \Delta Tw_j\right]$$

,

aufweist und wie eine kartesische Produkteinheit geschrieben wird
und

16. Verfahren nach einem der Ansprüche 1 bis 15, **dadurch gekennzeichnet, dass** n eine Ganzzahl kleiner oder gleich 3 ist, und dadurch, dass die Koordinaten ($x_j(i)$) eines gefilterten Photons (i), beziehungsweise ($x_j(i_{brut})$) eines rohen Photons ($i_{brut}$), wobei j eine Ganzzahl ist, die von 1 bis 3 variiert, einer Stelle und/ oder einem Zeitpunkt einer Emission des gefilterten Photons (i) beziehungsweise des Photons ($i_{brut}$) entsprechen, wobei die n Koordinaten in einem Triplett zusammengenommen sind, das durch eine erste räumliche Koordinate (x), eine zweite räumliche Koordinate (y) und eine zeitliche Koordinate (t) gebildet wird, wobei die räumlichen Koordinaten (x) und (y) im Verhältnis zu einer räumlichen Markierung einer Emissionsebene der Photonen der elektronischen Schaltung definiert sind und die zeitliche Koordinate (t) im Verhältnis zu einer zeitlichen Referenz eines elektrischen Anregungssignals der elektronischen Schaltung definiert ist.

17. Verfahren nach einem der Ansprüche 1 bis 16, **dadurch gekennzeichnet, dass** die Anzahl n an Aufnahmedimensionen gleich 3 ist, mit zwei räumlichen Dimensionen gemäß den Koordinaten (x), (y) und einer zeitlichen Koordinate t, wobei der Gewichtungsschritt der Photonen ein Raum-Zeit-Korrelationsverfahren STPC (Spatial Temporal Photo Correlation) ist, wobei die Größe des Gewichtungsfensters ($\Delta T_w$) durch ein Triplett (dl, dl, dt) gebildet ist, bei dem die räumlichen Komponenten der Größe ($\Delta T_w$) des Fensters identisch sind.

18. Verfahren nach einem der Ansprüche 1 bis 16, **dadurch gekennzeichnet, dass** das Verfahren eine Aufnahmetechnik wie die Emission von statischem Licht verwendet, die Anzahl n an Aufnahmedimensionen gleich 2 ist, mit zwei räumlichen Dimensionen gemäß den Koordinaten (x) und (y), wobei der Gewichtungsschritt der Photonen (206) ein räumliches Korrelationsverfahren ist, wobei die Größe des Gewichtungsfensters ($\Delta T_w$) durch eine Dublette (dl, dl) gebildet ist, bei der die beiden räumlichen Komponenten der Größe des Fensters identisch sind.

19. Verfahren nach einem der Ansprüche 1 bis 16, **dadurch gekennzeichnet, dass** das Verfahren eine Aufnahmetechnik wie die Emission mit zeitlicher Auflösung TRE (Time Resolved Emission) von statischem Licht verwendet, wobei die Anzahl n an Aufnahmedimensionen gleich 1 ist, mit einer einzigen zeitlichen Dimension gemäß der zeitlichen Koordinate (t), wobei der Gewichtungsschritt der Photonen (206) ein zeitliches Korrelationsverfahren ist, wobei die Größe des Gewichtungsfensters ($\Delta T_w$) durch einen Wert (dt) gebildet wird.

20. Computerprogrammprodukt, Programmanweisungen umfassend, um die Schritte des Verfahrens nach einem der Ansprüche 1 bis 19 umzusetzen, wenn das Programm auf einem Computer (60) läuft.

21. System zur Fehleranalyse einer integrierten elektronischen Schaltung, umfassend,
eine optische Messaufnahmevorrichtung (4), die imstande ist, isolierte Photonen zu erfassen, die von der elektronischen Schaltung emittiert werden, und Aufnahmedaten von Messungen der erfassten isolierten Photonen ($i_{acq}$) bereitzustellen,
einen Speicher (62), der imstande ist, die Aufnahmedaten einer Messung der erfassten isolierten Photonen, die eine Datenbank bilden, zu speichern,
einen Rechner (60), der imstande ist, ausgehend von der ersten Datenbank zur Aufnahme von Messungen der isolierten Photonen eine Datenbank von gefilterten Photonen (i) zu bestimmen, die für jedes gefilterte Photon (i) eine Speicherung enthält, die umfasst:

- eine räumliche und/ oder zeitliche Position P(i) des gefilterten Photons (i), die in einer räumlichen und/ oder zeitlichen Markierung mit n Dimensionen definiert ist, wobei n eine Ganzzahl kleiner oder gleich 3 ist, durch n Koordinaten ($x_j$(i), wobei j eine Ganzzahl ist, die von 1 bis n variiert, entsprechend einer Stelle und/ oder einem Zeitpunkt einer Emission des gefilterten Photons (i), wobei die n Koordinaten in einem Triplett zusammengenommen sind, das durch eine erste räumliche Koordinate (x), eine zweite räumliche Koordinate (y) und eine zeitliche Koordinate (t) gebildet wird, wobei die räumlichen Koordinaten (x) und (y) im Verhältnis zu einer räumlichen Markierung einer Emissionsebene der Photonen der elektronischen Schaltung definiert sind und die zeitliche Koordinate (t) im Verhältnis zu einer zeitlichen Referenz eines elektrischen Anregungssignals der elektronischen Schaltung definiert ist, und
- ein skalares Gewicht (W(i)), das dem gefilterten Photon (i) zugeordnet ist,

wobei der Rechner (60) imstande ist, einen Schritt einer elementaren Zusammenführung von Photonen um ein zentrales vorbestimmtes Photon (k) in einem Ereignis (ev(k)) umzusetzen, wobei der Schritt einer elementaren Zusammenführung darin besteht:

- da eine maximale Ereignisgröße ($\Delta$Tmaxev), die durch ein n-Tupel ($\Delta$Tmaxev$_j$) gebildet wird, vorbestimmt ist, um das zentrale Photon (k) einer Position (P(k)) herum nach Photonen (reg(k)) jeweiliger Positionen (P(reg(k))) zu suchen, die in einem räumlichen und/ oder zeitlichen Fenster (Fev(k)) eines Ereignisses enthalten sind, wobei das Ereignisfenster (Fev(k)) um (P(k)) herum zentriert ist und die Amplitude ($\Delta$Tmaxev) aufweist und wie eine kartesische Produkteinheit geschrieben wird

$$\prod_{j=1}^{n}\left[x_j(k) - \Delta T \max ev_j ; x_j(k) + \Delta T \max ev_j\right]$$

,

- wenn mindestens ein Photon (reg(k)) gefunden wurde, die Zusammenführung untereinander der gefundenen Photonen in dem Fenster (Fev(k)) durch Erstellen eines Ereignisses (ev(k)), das dem zentralen Photon (k) als Speicherung zugeordnet ist, die umfasst:

eine Position des Ereignisses gleich dem Mittelwert ($P_{moy}$(k)) der Positionen der Photonen (reg(k)), die in dem Fenster (Fev(k)) enthalten sind, und des Photons (k),
die maximalen und minimalen Koordinaten der Photonen, die in dem Fenster (Fev(k)) enthalten sind, das Photon (k), inklusive
einem Ereignisgewicht (Wev(k)) gleich der Summe der Gewichte der Gesamtheit der Photonen, die in dem Fenster (Fev(k)) enthalten sind,
wobei das System **dadurch gekennzeichnet ist, dass** der Rechner (60) imstande ist, in dem Schritt zum Bestimmen einer Datenbank gefilterter Photonen einen Schritt zum vorherigen Anordnen (204) der Aufnahmedaten von Messungen der gemessenen Photonen ($i_{acq}$) in Rohdaten von rohen Photonen ($i_{brut}$) und einen Schritt zum Umwandeln (206, 208) der Rohdaten von rohen Photonen ($i_{brut}$) in die Daten von gefilterten Photonen (i) umzusetzen;
dadurch, dass die Rohdaten für jedes rohe Photon ($i_{brut}$) eine Speicherung enthalten, die umfasst:

- eine räumliche und/ oder zeitliche Position ($P(i_{brut})$) des rohen Photons ($i_{brut}$), die in einer räumlichen und/ oder zeitlichen Markierung mit n Dimensionen definiert ist, und
- einen skalaren Empfindlichkeitswert des optischen Sensors ($S(i_{brut})$), der dem rohen Photon ($i_{brut}$) zugeordnet ist;

und dadurch, dass der Rechner (60) dazu in der Lage ist, in dem Schritt zum Umwandeln einen Gewichtungsschritt (206) zur Suche um das Photon ($i_{brut}$) einer Position ($P(i_{brut})$) von Photonen ($vois(i_{brut})$) jeweiliger Positionen ($P(vois(i_{brut}))$) umzusetzen, die in einem räumlichen und/ oder zeitlichen Gewichtungsfenster ($Fw(i_{brut})$) eines Photons enthalten sind, wobei das Gewichtungsfenster eines Photons Fw(i) ($P(i_{brut})$) enthält und eine Amplitude ($\Delta T_w$) aufweist, und zur Berechnung des Gewichts ($W(i_{brut})$), das dem gewichteten Photon ($i_{brut}$) zugeordnet ist, gleich einer dritten Funktion der Empfindlichkeiten ($S(vois(i_{brut}))$) der Photonen ($i_{brut}$, $vois(i_{brut})$), die im Fenster ($Fw(i_{brut})$) gefunden wurden.

## Claims

1. An image processing method for the analysis of defects of an integrated electronic circuit (24), the method being implemented from a first database of an image containing measurement acquisition data of photons isolated and detected by an optical measurements acquisition device (4); comprising the steps consisting in

- determining from the first database of isolated photons ($i_{acq}$) measurements acquisition data, a database of filtered photons (i) containing for each filtered photon (i) a record which comprises:

• a spatial and/or temporal position (P(i)) of the filtered photon (i) defined in a n-dimension spatial and/or temporal reference frame, and
• a scalar weight (W(i)) associated to the filtered photon (i),

the method comprising at least one elementary step (716) of grouping together filtered photons around a predetermined central filtered photon (k) at an event (ev(k)), the or each elementary grouping step comprising:

- the research around the central photon (k) with a position (P(k)) of photons (reg(k)) having respective positions (P(reg(k))) contained within an event spatial and/or temporal window (Fev(k)) containing (P(k)) and having a predetermined magnitude (ΔTmaxev),
- when at least one photon (P(reg(k))) has been found, grouping together the photons found within the window (Fev(k)) by creating an event ((ev(k))) associated to the central photon (k) as a record which comprises:

a position of the event ($P_{moy}$(k)) equal to a first function of the positions of the photons (k, Reg(k)) contained within the window (Fev(k)),

an event weight (Wev(k)) equal to a second function of the scalar weights (W(k), W(reg(k))) of all the photons contained within the window (Fev(k)),

the method being **characterized in that** the step of determining a database of filtered photons (i) from the database of measurements acquisition data of the isolated photons comprises a preliminary step (204) of arranging the measurements acquisition data of the measured photons ($i_{acq}$) into raw data of raw photons ($i_{brut}$) and a step (206, 208) of converting the raw data of the raw photons ($i_{brut}$) into the data of filtered photons (i); **in that**

the raw data contain for each raw photon ($i_{brut}$) a record which comprises:

- a spatial and/or temporal position ($P(i_{brut})$) of the raw photon ($i_{brut}$) defined in a n-dimension spatial and/or temporal reference frame, and
- a scalar value of the sensitivity of the optical sensor ($S(i_{brut})$) associated to the raw photon ($i_{brut}$); and **in that**

the step (206, 208) of converting the raw data of the raw photons ($i_{brut}$) into the data of filtered photons (i) comprises a step (206) of weighting the research around the photon ($i_{brut}$) with a position ($P(i_{brut})$) of photons ($vois(i_{brut})$) having respective positions ($P(vois(i_{brut}))$) contained within a photon weighting spatial and/or temporal window ($F_W(i_{brut})$), the photon weighting window (Fw(i)) containing ($P(i_{brut})$) and having a magnitude ($\Delta T_W$), and calculating the weight ($W(i_{brut})$) associated to the weighted photon ($i_{brut}$) equal to a third function of the sensitivities ($S(vois(i_{brut}))$) of the photons ($i_{brut}$, $vois(i_{brut})$) found within the window ($F_W(i_{brut})$).

2. The image processing method according to claim 1, **characterized in that** the record of an event comprises the maximum and minimum coordinates of the photons (k, reg(k)) contained within the window (Fev(k)).

3. The image processing method according to any one of claims 1 to 2, **characterized in that** the first function is an unweighted average of the positions ($P_{moy}(k)$) of the photons (k, reg(k)) contained within the window (Fev(k)).

4. The image processing method according to any one of claims 1 to 2, **characterized in that** the first function is a weighted average of the positions ($P_{moy}(k)$) of the photons (k, reg(k)) contained within the window (Fev(k)) assigned with their respective scalar weight (W(k), W(reg(k))), such that the position of the event (ev(k)) is a barycenter of the photons (k, reg(k)).

5. The image processing method according to any one of claims 1 to 4, **characterized in that** the second function is the sum of the respective weights (W(k), W(reg(k))) of the photons (k, reg(k)) contained within the window (Fev(k)).

6. The image processing method according to any one of claims 1 to 5, **characterized in that** it comprises a step (602) of grouping together all the filtered photons (i) of the database into events, the grouping phase (602) consisting in applying the elementary grouping step to each photon (i) only once, the photon (i) being considered either as a central photon, or as a photon found within an event window.

7. The image processing method according to claim 6, **characterized in that** the created events (ev(k)) are combined into a database containing only but events.

8. The image processing method according to any one of claims 1 to 7, **characterized in that** it comprises a step (608) of filtering the events (ev(k)) consisting in suppressing the events (ev(k)) whose event weight (Wev(k)) is lower than a predetermined threshold value (Sev), the remaining events being filtered events ($ev(k_{filtre})$).

9. The image processing method according to any one of claims 1 to 6, **characterized in that** it comprises a step (614) of creating an image of the filtered events, respectively the non-filtered events (ev(k)), representing the filtered event(s) ($ev(k_{filtre})$), respectively the non-filtered event(s) (ev(k)), in the form of segments, squares or volumes each having a position, a size and a color, the size and the position of the segment, of the square or of the volume being determined by the coordinates of the filtered event ($ev(k_{filtre})$), respectively the non-filtered event (ev(k)), and the color is a function of the weight ($Wev(k_{filtre})$) of the filtered event, respectively the weight (Wev(k)) of the non-filtered event (ev(k)).

10. The image processing method according to any one of claims 1 to 9, **characterized in that** it comprises a step (224) of comparing at least one event (ev(k)) determined from the first database with at least one event determined from a second database called reference database and corresponding to an identical electronic circuit in proper operating order, and a step of identifying the non-similar events derived respectively from the first database and the second database.

11. The image processing method according to any one of claims 1 to 10, **characterized in that** it comprises a step of collecting measurements acquisition data of photons ($i_{acq}$) isolated and detected by an optical measurements acquisition device (4), the measurements data forming an image.

12. The image processing method according to any one of claims 1 to 11, **characterized in that**
the spatial and/or temporal position (P(i)) of the filtered photon (i) is defined by n coordinates ($x_j$(i) with j being an integer varying from 1 to n, corresponding to a location and/or an emission time of the filtered photon (i), the n coordinates being brought together in a n-tuple formed by n-1 spatial coordinates and one temporal coordinate (t), the spatial coordinates being defined relative to a photons emission spatial reference frame of the electronic circuit and the temporal coordinate (t) being defined relative to a time reference of an electrical excitation signal of the electronic circuit,
the event maximum size ($\Delta Tmaxev$) is formed by a n-tuple ($\Delta Tmaxev_j$), j being an integer varying from 1 to n, and
the event spatial and/or temporal window ($Fev(k)$) is centered around ($P(k)$) with a magnitude ($\Delta Tmaxev$) and is written as a Cartesian product set $\prod_{j=1}^{n}[x_j(k) - \Delta Tmaxev_j;\ x_j(k) + \Delta Tmaxev_j]$.

13. The image processing method according to any one of claims 1 to 12, **characterized in that** the third function is the sum of the sensitivities ($S(vois(i_{brut}))$) of the photons ($i_{brut}$, $vois(i_{brut})$) found within the window ($Fw(i_{brut})$).

14. The image processing method according to any one of claims 1 to 13, **characterized in that** the step (206, 208) of converting the raw data of the raw photons ($i_{brut}$) into the data of filtered photons (i) comprises a step (208) of filtering the weighted raw photons ($i_{brut}$) following the weighting step (206) consisting in suppressing the weighted raw photons whose weight ($W(i_{brut})$) is lower than a predetermined photons filtering threshold value ($S_{filt}$), the remaining weighted raw photons constituting the filtered photons (i).

15. The image processing method according to any one of claims 1 to 14, **characterized in that**
the spatial and/or temporal position ($P(i_{brut})$) of the filtered photon (i) is defined by n coordinates ($x_j(i_{brut})$ with j being an integer varying from 1 to n, corresponding to a location and/or an emission time of the raw photon ($i_{brut}$), the n coordinates being brought together in a n-tuple formed by n-1 spatial coordinates and one temporal coordinate (t), the spatial coordinates being defined relative to a photons emission spatial reference frame of the electronic circuit and the temporal coordinate (t) being defined relative to a time reference of an electrical excitation signal of the electronic circuit,
the raw photon weighting size ($\Delta T_W$) is formed by a n-tuple ($\Delta T_{Wj}$), and
the spatial and/or temporal window ($F_W(i_{brut})$) is centered around ($P(i_{brut})$) with a magnitude ($\Delta T_W$) and is written as a Cartesian product set $\prod_{j=1}^{n}[x_j(i_{brut}) - \Delta T_{Wj};\ x_j(i_{brut}) + \Delta T_{Wj}]$.

16. The image processing method according to any one of claims 1 to 15, **characterized in that** n is an integer smaller than or equal to 3 and **in that** the coordinates ($x_j$(i)) of a filtered photon (i), respectively ($x_j(i_{brut})$) of a raw photon ($i_{brut}$), with j being an integer varying from 1 to 3, correspond to a location and/or an emission time of the filtered photon (i), respectively the photon ($i_{brut}$), the n coordinates being brought together in a triplet formed by a first spatial coordinate (x), a second spatial coordinate (y) and a temporal coordinate (t), the spatial coordinates (x) and (y) being defined relative to a spatial reference frame of a photons emission plane of the electronic circuit and the temporal coordinate (t) being defined relative to a time reference of an electrical excitation signal of the electronic circuit.

17. The image processing method according to any one of claims 1 to 16, **characterized in that** the number n of acquisition dimensions is equal to 3 with two spatial dimensions according to the coordinates (x), (y) and a temporal dimension t, the step of weighting the photons is a Spatial Temporal Photo Correlation STPC process with the size of the weighting window ($\Delta T_W$) formed by a triplet (dl, dl, dt) wherein the spatial components of the size ($\Delta T_W$) of the window are identical.

**18.** The image processing method according to any one of claims 1 to 16, **characterized in that** the method uses an acquisition technique such as the emission of a static light, the number n of acquisition dimensions is equal to 2 with two spatial dimensions according to the coordinates (x) and (y), the step (206) of weighting the photons is a spatial correlation process with the size of the weighting window ($\Delta T_W$) formed by a doublet (dl, dl) wherein the two spatial components of the size of the window are identical.

**19.** The image processing method according to any one of claims 1 to 16, **characterized in that** the method uses an acquisition technique such as the Time Resolved Emission TRE of a static light, the number n of acquisition dimensions is equal to 1 with one single temporal dimension according to the temporal coordinate (t), the step (206) of weighting the photons is a temporal correlation process with the size of the weighting window ($\Delta T_W$) formed by a value (dt).

**20.** A computer program product comprising program instruction for implementing the steps of the method according to any one of claims 1 to 19 when said program functions on a computer (60).

**21.** A system for the analysis of defects of an integrated electronic circuit comprising
an optical measurements acquisition device (4) capable of detecting isolated photons emitted by the electronic circuit and outputting measurements acquisition data of the detected isolated photons ($i_{acq}$),
a memory (62) capable of saving the measurement acquisition data of the detected isolated photons forming a database,
a calculator (60) capable of determining from the database of isolated photons measurements acquisition data a database of filtered photons (i) containing for each filtered photon (i) a record which comprises:

- a spatial and/or temporal position P(i) of the filtered photon (i) defined in a n-dimension spatial and/or temporal reference frame, with n being an integer smaller than or equal to 3, by n coordinates ($x_j(i)$) with j being an integer varying from 1 to n, corresponding to a location and/or an emission time of the filtered photon (i), the n coordinates being brought together in a triplet formed by a first spatial coordinate (x), a second spatial coordinate (y) and a temporal coordinate (t), the spatial coordinates (x) and (y) being defined relative to a spatial reference frame of a photons emission plane of the electronic circuit and the temporal coordinate (t) being defined relative to a time reference of an electrical excitation signal of the electronic circuit, and
- a scalar weight (W(i)) associated to the filtered photon (i),

the calculator (60) being capable of implementing an elementary step of grouping together photons around a predetermined central photon (k) at an event (ev(k)), the elementary grouping step consisting in:

- an event maximum size ($\Delta Tmaxev$) formed by a n-tuple ($\Delta Tmaxev_j$) being predetermined, searching around the predetermined photon (k) with a position (P(k)) the photons (reg(k)) having respective positions (P(reg(k))) contained within an event spatial and/or temporal window (Fev(k)), the event window (Fev(k)) being centered around (P(k)) with a magnitude ($\Delta Tmaxev$) and being written as a product set

$$\prod_{j=1}^{n}[x_j(k) - \Delta Tmaxev_j;\ x_j(k) + \Delta Tmaxev_j],$$

- when at least one photon (reg(k)) has been found, grouping together the photons found within the window (Fev(k)) by creating an event (ev(k)) associated to the photon (k) as a record which comprises:

a position of the event equal to the average ($P_{moy}(k)$) of the positions of the photons (reg(k)) contained within the window (Fev(k)) and the photon (k),
the maximum and minimum coordinates of the photons contained within the window (Fev(k)), including the photon (k),
an event weight (Wev(k)) equal to the sum of the weights of all the photons contained within the window (Fev(k)).
the system being **characterized in that** the calculator (60) is capable of implementing, at the step of determining a filtered photons database, a preliminary step (204) of arranging the measurements acquisition data of the measured photons ($i_{acq}$) into raw data of raw photons ($i_{brut}$) and a step (206, 208) of converting the raw data of the raw photons ($i_{brut}$) into the filtered photons (i) data;
**in that** the raw data contain for each raw photon ($i_{brut}$) a record which comprises:

- a spatial and/or temporal position (P($i_{brut}$)) of the raw photon ($i_{brut}$) defined in a n-dimension spatial and/or temporal reference frame, and
- a scalar value of the sensitivity of the optical sensor ($S(i_{brut})$) associated to the raw photon ($i_{brut}$);

and **in that** the calculator (60) is capable of implementing, at the conversion step, a step (206) of weighting the research around the photon ($i_{brut}$) with a position ($P(i_{brut})$) of photons ($vois(i_{brut})$) having respective positions ($P(vois(i_{brut}))$) contained within a photon weighting spatial and/or temporal window ($F_W(i_{brut})$), the photon weighting window ($Fw(i)$) containing ($P(i_{brut})$) with a magnitude ($\Delta T_W$), and calculating the weight ($W(i_{brut})$) associated to the weighted photon ($i_{brut}$) equal to a third function of the sensitivities ($S(vois(i_{brut}))$) of the photons ($i_{brut}$, $vois(i_{brut})$) found within the window ($F_W(i_{brut})$).

FIG.1

200

202

204

206

208

210    Oui    212

Non

216    Non

Oui

214

220    Non

Oui

218

222

224    230

226

228    Non

Oui

232

FIG.2

EP 2 409 276 B1

204

302

304

306  Non

Oui

308

310

312

314

316

**FIG.3**

208

502

504

506

508

510  Oui

Non

514

516

512

**FIG.5**

FIG.4

602

702

704

706

708

710

714

712

Non

726

Oui

716

718

720

722

Oui

724

## FIG.7

EP 2 409 276 B1

222

602

604

606

608

610

Non

Oui

612

614

**FIG.6**

224

802

804

806

808

810

812

814

**FIG.8**

FIG.9

FIG.10

FIG.11

FIG.12

FIG.13

FIG.14

FIG.15

FIG.16

FIG.17

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- STPC-PICA : Spatial Temporal Photon Correlation for Faster IC analysis. **R. DESPLATS et al.** French Space Agency. CNES

- **R. DESPLATS et al.** A new approach for faster IC analysis with PICA. *Physical and Faiure Analysis of Integrated Circuits,* 2003, 45-53